# EUROPEAN PATENT APPLICATION

(11) **EP 4 607 572 A1**
(43) Date of publication of application: **27.08.2025**
(21) Application number: 23879856.5
(22) Date of filing: 19.10.2023
(51) Int. Cl.: H01L 21/205

(54) **SEMICONDUCTOR SUBSTRATE, APPARATUS AND METHOD FOR PRODUCING SEMICONDUCTOR SUBSTRATE, AND METHOD FOR PRODUCING SEMICONDUCTOR DEVICE**

(30) Priority: 19.10.2022 WO PCT/JP2022/038956
(71) Applicant: Kyocera Corporation, Kyoto-shi, Kyoto 612-8501 (JP)
(72) Inventor: KAMIKAWA, Takeshi, Kyoto-shi, Kyoto 612-8501 (JP); AOKI, Yuta, Kyoto-shi, Kyoto 612-8501 (JP); TAKEUCHI, Kazuma, Kyoto-shi, Kyoto 612-8501 (JP); MASAKI, Katsuaki, Kyoto-shi, Kyoto 612-8501 (JP); YAMASHITA, Fumio, Kyoto-shi, Kyoto 612-8501 (JP)
(74) Representative: Viering, Jentschura & Partner mbB Patent- und Rechtsanwälte
(86) International application number: PCT/JP2023/037822
(87) International publication number: WO 2024/085213

(57) **Abstract**

Provided are a template substrate including a first seed region and a growth suppression region aligned in a first direction, and a first semiconductor part located above the template substrate. The first semiconductor part includes a first base portion located on the first seed region, and a first wing portion connected to the first base portion and facing the growth suppression region via a first void space. The first wing portion includes a wing end located above the growth suppression region. **In** the first void space, a ratio of a width in the first direction with respect to a thickness under the wing end is 5.0 or more.

## Description

### TECHNICAL FIELD

The present disclosure relates to a semiconductor substrate and the like.

### BACKGROUND OF INVENTION

A technique for forming a semiconductor element using gallium nitride (GaN) on a silicon substrate or a sapphire substrate has been developed. However, when a GaN layer is formed on a heterogeneous substrate, threading dislocations are generated from an interface between different materials (an interface between a substrate and a formed film) at a defect density on the order of 10⁸cm⁻² on a sapphire substrate and on the order of 10⁹cm⁻² on a silicon substrate, thereby deteriorating the characteristics and reliability of devices formed thereon. Thus, an Epitaxial Lateral Overgrowth (ELO) method has been studied as a technique for forming a GaN layer having a low defect density on the heterogeneous substrate. For example, a mask pattern in which a GaN layer does not grow is formed on a base substrate including a heterogeneous substrate and a seed layer (a GaN layer or the like), and the GaN layer is laterally grown on a mask portion by using the seed layer exposed in an opening portion without the mask portion as a growth starting point, whereby the defect density of the GaN layer on the mask portion can be reduced (Patent Document 1). However, when the laterally grown GaN layer comes into contact with the mask portion, the flatness of the GaN layer may be deteriorated depending on film-forming conditions.

In Patent Document 2, a semiconductor layer is grown in a lateral direction on a void space, and a device layer (laminated semiconductor film) is also formed on a lower surface (back surface) of the semiconductor layer.

### CITATION LIST

### PATENT LITERATURE

Patent Document 1: JP 2013-251304 A
Patent Document 2: JP 2017-535051 T

### SUMMARY

### PROBLEM TO BE SOLVED

The technique of Patent Document 2 has a problem in that a device layer having a wide width cannot easily be formed.

### SOLUTION TO PROBLEM

A semiconductor substrate according to the present disclosure includes a template substrate including a first seed region and a growth suppression region aligned in a first direction, and a first semiconductor part located above the template substrate, the first semiconductor part includes a first base portion located on the first seed region, and a first wing portion connected to the first base portion and facing the growth suppression region via a first void space, the first wing portion includes a wing end located above the growth suppression region, and in the first void space, a ratio of a width in the first direction with respect to a thickness under the wing end is 5.0 or more.

### ADVANTAGEOUS EFFECT

A device layer (functional layer) having a wide width can be formed.

### BRIEF DESCRIPTION OF THE DRAWINGS

FIG. 1 is a plan view illustrating a configuration of a semiconductor substrate according to the present embodiment.
FIG. 2 is a cross-sectional view illustrating the configuration of the semiconductor substrate according to the present embodiment.
FIG. 3 is a cross-sectional view illustrating the configuration of the semiconductor substrate according to the present embodiment.
FIG. 4 is a cross-sectional view illustrating the configuration of the semiconductor substrate according to the present embodiment.
FIG. 5 is a cross-sectional view illustrating the configuration of the semiconductor substrate according to the present embodiment.
FIG. 6 is a cross-sectional view illustrating the configuration of the semiconductor substrate according to the present embodiment.
FIG. 7 is a cross-sectional view illustrating the configuration of the semiconductor substrate according to the present embodiment.
FIG. 8 is a cross-sectional view illustrating the configuration of the semiconductor substrate according to the present embodiment.
FIG. 9 is a plan view illustrating the configuration of the semiconductor substrate according to the present embodiment.
FIG. 10A is a flowchart showing a manufacturing method of a semiconductor substrate according to the present embodiment.
FIG. 10B is a flowchart showing a manufacturing method of a semiconductor substrate according to the present embodiment.
FIG. 11 is a block diagram illustrating a manufacturing apparatus of a semiconductor substrate according to the present embodiment.
FIG. 12 is a cross-sectional view illustrating a configuration of a semiconductor substrate according to Example 1.
FIG. 13 is a cross-sectional view illustrating a manufacturing method of a semiconductor substrate according to Example 1.
FIG. 14 illustrates Raman spectra of a base portion and a wing portion of an ELO layer according to a comparative example.
FIG. 15 illustrates Raman spectra of a base portion and a wing portion of an ELO layer (a semiconductor part) according to Example 1.
FIG. 16 is a plan view of a semiconductor substrate including an upper layer portion.
FIG. 17 is a cross-sectional view of the semiconductor substrate including the upper layer portion.
FIG. 18 is a plan view illustrating a method of element isolation in Example 1.
FIG. 19 is a cross-sectional view illustrating the method of the element isolation in Example 1.
FIG. 20 is a schematic view illustrating a configuration of an electronic device according to Example 1.
FIG. 21 is a cross-sectional view illustrating a configuration of a semiconductor substrate according to Example 4.
FIG. 22 is a graph showing a result of an XRD reflection scan measurement for the ELO layer according to a comparative example.
FIG. 23 is a graph showing a result of an XRD reflection scan measurement for the semiconductor part according to Example 1.
FIG. 24 is a plan view illustrating a configuration of a semiconductor substrate according to Example 5.
FIG. 25 is a cross-sectional view illustrating a configuration of a semiconductor substrate according to Example 5.
FIG. 26 is a cross-sectional view illustrating a method of manufacturing the semiconductor substrate in FIG. 25.
FIG. 27 is a cross-sectional view illustrating a method of manufacturing a template substrate in FIG. 25.
FIG. 28 is a cross-sectional view illustrating a method of manufacturing a template substrate.
FIG. 29 is a cross-sectional view illustrating a method of manufacturing a template substrate.
FIG. 30 is a cross-sectional view illustrating a configuration of a semiconductor substrate according to Example 6.
FIG. 31 is a cross-sectional view illustrating a configuration of a semiconductor substrate according to Example 6.
FIG. 32 is a cross-sectional view illustrating a configuration of a semiconductor substrate according to Example 7.
FIG. 33 is a flowchart showing a method of manufacturing a semiconductor device according to Example 8.
FIG. 34 is a cross-sectional view illustrating the method of manufacturing a semiconductor device according to Example 8.

### DESCRIPTION OF EMBODIMENTS

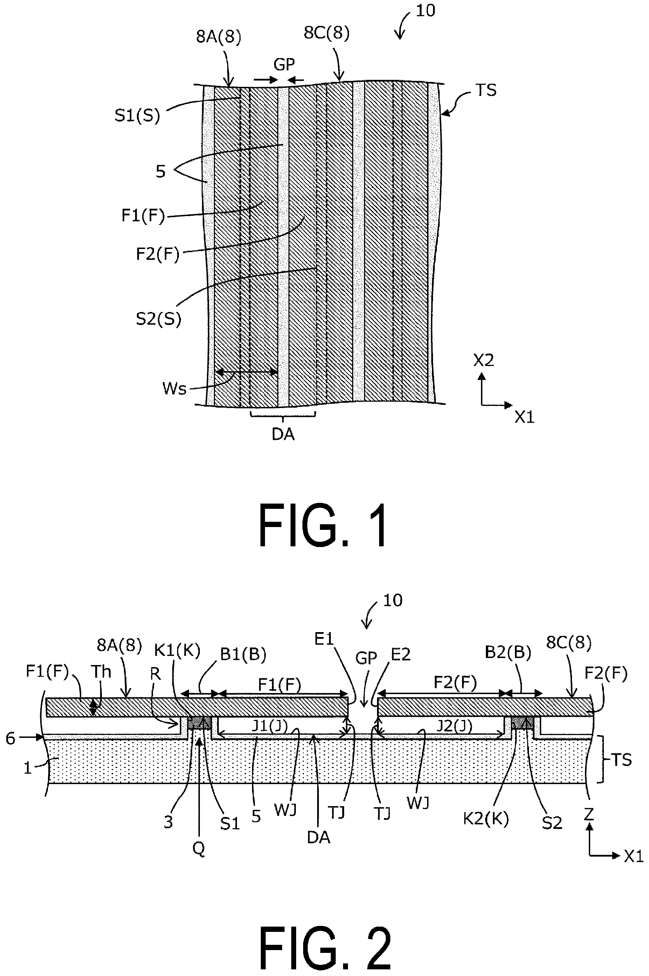

FIG. 1 is a plan view illustrating a configuration of a semiconductor substrate according to the present embodiment. FIG. 2 is a cross-sectional view illustrating the configuration of the semiconductor substrate according to the present embodiment. As illustrated in FIGs. 1 and 2, a semiconductor substrate 10 includes a template substrate TS including a first seed region S1 and a growth suppression region (a non-seed region) DA that are aligned in a first direction X1, and a first semiconductor part 8A located above the template substrate TS. The first semiconductor part 8A includes a first base portion B1 located on the first seed region S1 and a first wing portion F1 connected to the first base portion B1 and facing the growth suppression region DA via a first void space J1. The first wing portion F1 includes an edge (wing end) E1 located above the growth suppression region DA. A ratio of a width WJ of the first void space J1 in the first direction X1 with respect to a thickness TJ of the first void space J1 (an aspect ratio of the void space) is equal to or greater than 5.0. According to such a configuration, a device layer (functional layer) having a large width can be formed on the first wing portion F1. The thickness TJ may be the thickness of the first void space J1 below the wing end E1 (the length in a c-axis direction between a lower surface of the wing end E1 and an upper surface of the template substrate TS). The width of the first wing portion F1 in the first direction X1 may be equal to or greater than 5.0 times the thickness TJ of the first void space J1.

The template substrate TS may include a mask pattern 6 including a mask portion 5 functioning as the growth suppression region DA and a first opening portion K1 functioning as the first seed region S1 (exposing an upper surface of the seed 3 as the first seed region S1). Specifically, the surface (upper surface) of the mask portion 5 serves as the growth suppression region DA. The template substrate TS may include a main substrate 1 (a heterogeneous substrate) having a different lattice constant from that of the first semiconductor part 8A, and a seed part 3. The template substrate TS may have a ridge portion R on the upper surface side, and the first seed region S1 may be located on an upper surface of the ridge portion R. Specifically, the surface (upper surface) of the seed part 3 serves as the first seed region S1.

The first void space J1 is a space between the growth suppression region DA and the first wing portion F1. A direction from the main substrate 1 to the first semiconductor part 8A is referred to as an "upward direction". A view in which a target subject is observed in a line of sight parallel to a normal direction of the semiconductor substrate 10 (including a view through the target subject) is referred to as a "plan view". The first seed region S1 (the surface of the seed part 3) and the growth suppression region DA (the surface of the mask portion 5) have different positions in a thickness direction (up-down direction) of the substrate, but may be aligned in the first direction X1 (a direction orthogonal to the thickness direction of the substrate) in a plan view.

The first semiconductor part 8A contains a nitride semiconductor as a main constituent. For example, the nitride semiconductor may be expressed by AlxGayInzN (0 ≤ x ≤ 1; 0 ≤ y ≤ 1; 0 ≤ z ≤ 1; x + y + z = 1). Specific examples of the nitride semiconductor include a GaN-based semiconductor, an aluminum nitride (AlN) semiconductor, an indium aluminum nitride (InAlN) semiconductor, and an indium nitride (InN) semiconductor. The GaN-based semiconductor is a semiconductor containing gallium atoms (Ga) and nitrogen atoms (N). Typical examples of the GaN-based semiconductor include GaN, AlGaN, AlGaInN, and InGaN.

The first semiconductor part 8A may be a doped type semiconductor (for example, an n-type semiconductor including a donor) or a non-doped type semiconductor. The semiconductor substrate refers to a substrate containing a semiconductor. The main substrate 1 of the template substrate TS may contain a semiconductor (for example, silicon or silicon carbide), or may not contain a semiconductor. Examples of the main substrate 1 not containing a semiconductor include a sapphire substrate. The main substrate 1 may be a stand-alone substrate (wafer). The main substrate 1 and the seed part 3 may be collectively referred to as a base substrate. The template substrate TS including the base substrate and the mask pattern 6 may be referred to as a growth substrate.

The first direction X1 may be an a-axis direction (<11-20> direction) of the first semiconductor part 8A (nitride semiconductor such as GaN). A second direction X2 may be an m-axis direction (<1-100> direction) of the first semiconductor part 8A. A thickness direction Z of the semiconductor substrate 10 may be a c-axis direction (<0001> direction) of the first semiconductor part 8A.

The first semiconductor part 8A can be formed by an Epitaxial Lateral Overgrowth (ELO) method with the seed part 3 exposed under the first opening portion K1 serving as a starting point. Among the first semiconductor part 8A, the base portion B1 located above the first opening portion K1 serves as a dislocation succession portion in which a large number of threading dislocations occur. The first wing portion F1 located above the mask portion 5 serves as a low defect portion having a lower threading dislocation density than that of the dislocation succession portion. A second semiconductor part 8C grows in a lateral direction on the mask portion 5, with the seed part 3 exposed under a second opening portion K2 serving as a starting point, and the growth is stopped before the second semiconductor part 8C meets the first semiconductor part 8A.

As described above, the edge E1 of the first wing portion F1 is formed above the growth suppression region DA and the aspect ratio of the first void space J1 (the ratio of the width W1 in the first direction X1 relative to the thickness TJ) is set to 5.0 or more. Therefore, the first wing F1 having a large width and high crystallinity (low defect density) can be rapidly formed and the flatness of the first wing F1 can be improved. When an upper layer portion (a device layer, a functional layer) including an active layer is formed on the first semiconductor part 8A, a phenomenon in which a material of the upper layer portion flows to the back surface of the first wing portion F1 can be suppressed. The upper layer portion may include, for example, a nitride semiconductor layer (including an active layer).

The semiconductor substrate 10 may include a second semiconductor part 8C located above the template substrate TS. The template substrate TS may include a second seed region S2 adjacent to the first seed region S1 via the growth suppression region DA in a plan view. The second semiconductor part 8C may include a second base portion B2 located on the second seed region S2 and a second wing portion F2 connected to the second base portion B2 and facing the growth suppression region DA with a second void space J2 interposed therebetween. The first wing portion F1 and the second wing portion F2 may be aligned in the first direction X1 with a gap GP interposed therebetween. The ratio of the width WJ of the second void space J2 in the first direction X1 with respect to the thickness TJ may be equal to or greater than 5.0. The thickness TJ may be the thickness below a wing end E2 in the second void space J2.

In the following description, the first semiconductor part 8A and the second semiconductor part 8C may be collectively referred to as a semiconductor part (semiconductor layer) 8, the first wing portion F1 and the second wing portion F2 may be collectively referred to as a wing portion F, the first base B1 and the second base B2 may be collectively referred to as a base B, the first void space J1 and the second void space J2 may be collectively referred to as a void space J, the first opening portion K1 and the second opening portion K2 of the mask pattern 6 may be collectively referred to as an opening K, and the first seed region S1 and the second seed region S2 may be collectively referred to as a seed region S.

A ratio of the width of the first wing portion F1 in the first direction X1 with respect to the thickness of the first wing portion F1 may be 2.0 or more, 5.0 or more, 10 or more, 20 or more, 50 or more, 100 or more, or 200 or more. A ratio of the thickness of the first wing portion F1 with respect to the width of the first wing portion F1 is set to be equal to or less than 1/2, and thus, a deviation between a c-axis direction of the first base portion B1 and a c-axis direction of a front end of the first wing portion F1 is equal to or less than 0.2°. For example, the width of the first wing portion F1 in the first direction X1 may be equal to or greater than 7.0 µm, equal to or greater than 10.0 µm, equal to or greater than 20.0 µm, equal to or greater than 40.0 µm, or equal to or greater than 100 µm. The width of the first wing portion F1 in the first direction X1 is preferably equal to or smaller than 80.0 µm. This can reduce the risk that the semiconductor part 8 is warped in a substrate direction due to gravity. For example, the thickness of the first wing portion F1 may be equal to or less than 10.0 µm, equal to or less than 5.0 µm, or equal to or less than 2.0 µm. As illustrated in FIG. 2, a width of the gap GP may be larger than the thickness of the first void space J1. The ratio of the width of the first wing portion F1 with respect to the width of the first base portion B1 may be equal to or greater than 3.0. The first void space J1 may have a thickness being equal to or smaller than 3.0 µm. The thicknesses of the first wing portion F1 and the first base B1 may be the same. The mask portion 5 may have a thickness being equal to or smaller than 1 µm, or equal to or smaller than 50 nm. The seed part 3 may be made of a nitride semiconductor (AlN, AlON, GaN-based semiconductor, or the like) containing 2 × 10¹⁸/cm³ or more of argon or oxygen.

As illustrated in FIG. 1, each of the first seed region S1 and the growth suppression region DA may have a shape whose longitudinal direction is a second direction X2 orthogonal to the first direction X1. The main substrate 1 is a silicon substrate, a sapphire substrate, or a silicon carbide substrate, and the first semiconductor part 8A may contain a nitride semiconductor (for example, a GaN-based semiconductor).

As illustrated in FIG. 2, the template substrate TS may include the ridge portion R on an upper surface side, and the ridge portion R may include the seed part 3. An upper surface of the ridge portion R may consist of the seed part 3, and a side surface of the ridge portion R may consist of the mask portion 5. That is, the upper surface of the ridge portion R may include the seed part 3, and the side surface of the ridge portion R may include the mask portion 5. The seed part 3 may be provided on the upper surface of the ridge portion R, and the side surface of the ridge portion R may consist of the mask portion 5 and not include the seed part 3. The seed part 3 may be locally arranged in the ridge portion R and may not be arranged under the mask portion 5.

The main substrate 1 may include a protruding portion Q on the upper surface side. The seed part 3 may be located on the protruding portion Q. The side surface of the ridge portion R may not contact the first wing portion F1. The entire side surface of the ridge portion R may face the first void space J1. Thus, a contact surface area between the ridge portion R and the wing portion F1 is reduced, and defects of the wing portion F1 can be reduced. The seed part 3 may not be disposed under the mask portion 5. The nitride semiconductor included in the first semiconductor part 8A is a GaN-based semiconductor. The first void space J1 may have a width-to-thickness ratio of 20.0 or more. The first semiconductor part 8A may include a pair of two first wing portions F1 extending from the first base portion B1 in the first direction X1 and in a direction opposite to the first direction X1.

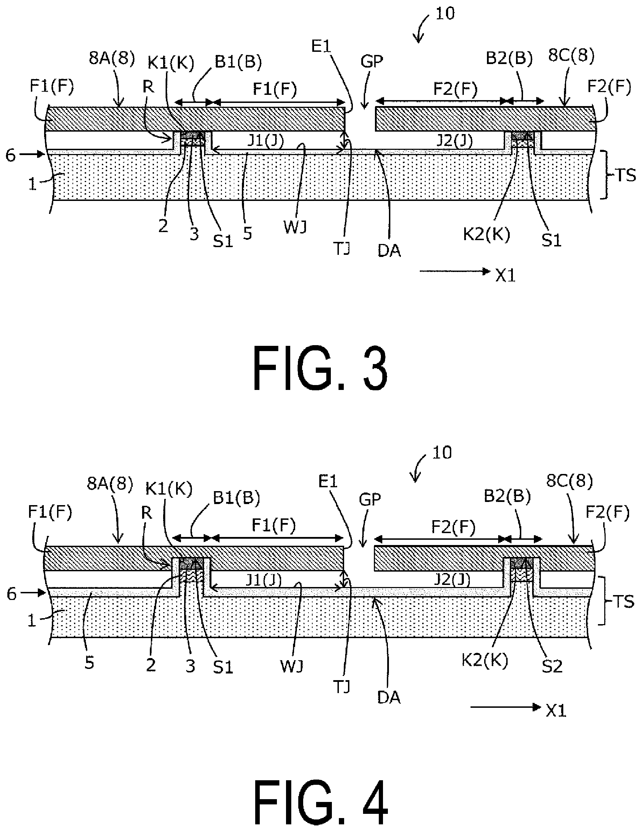

FIG. 3 is a cross-sectional view illustrating a configuration of the semiconductor substrate according to the present embodiment. As illustrated in FIG. 3, the ridge portion R may include a buffer part 2 and the seed part 3. In this case, an underlying portion including the buffer part 2 and the seed part 3 may be arranged in a stripe shape.

FIG. 4 is a cross-sectional view illustrating a configuration of the semiconductor substrate according to the present embodiment. As illustrated in FIG. 4, the first wing portion F1 may be thicker than the first base portion B1. The side surface of the ridge portion R (the mask portion 5) may be in contact with the first wing portion F1. When the first wing portion F1 does not contact the growth suppression region DA (the mask portion 5), the void space J1 can be formed, and thus, no problem arises.

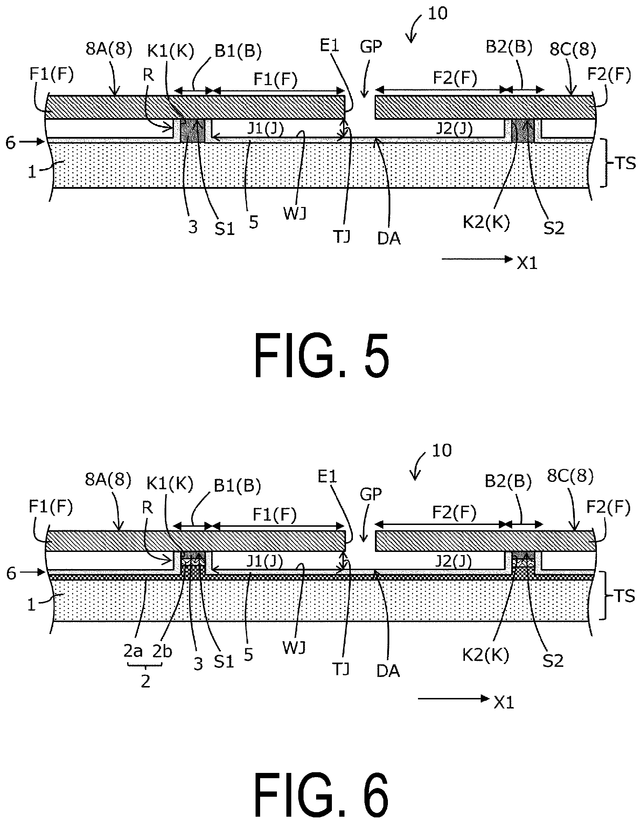

FIG. 5 is a cross-sectional view illustrating a configuration of the semiconductor substrate according to the present embodiment. As illustrated in FIG. 5, the ridge portion R may be located on the flat upper surface of the main substrate 1.

FIG. 6 is a cross-sectional view illustrating a configuration of the semiconductor substrate according to the present embodiment. As illustrated in FIG. 6, the buffer part 2 may include a lower portion 2a and an upper portion 2b. The lower portion 2a may have a planar shape. The seed part 3 and the upper portion 2b may not be disposed below the mask portion 5, but the lower portion 2a may be disposed below the mask portion 5. The ridge portion R may include the upper portion 2b of the buffer part 2.

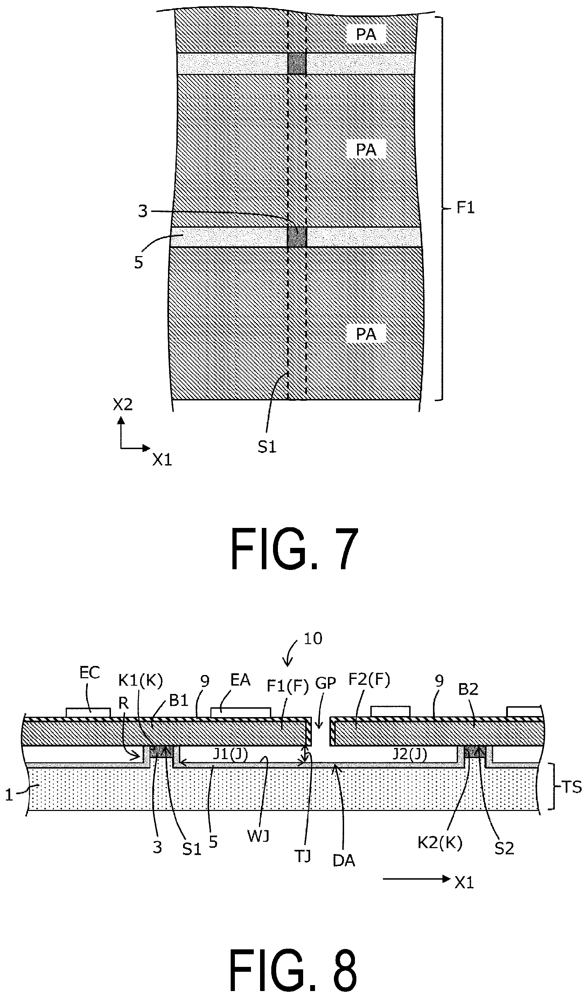

FIG. 7 is a cross-sectional view illustrating a configuration of the semiconductor substrate according to the present embodiment. As illustrated in FIG. 7, the first wing portion F1 may be divided into a plurality of parts PA aligned in the second direction X2 orthogonal to the first direction X1.

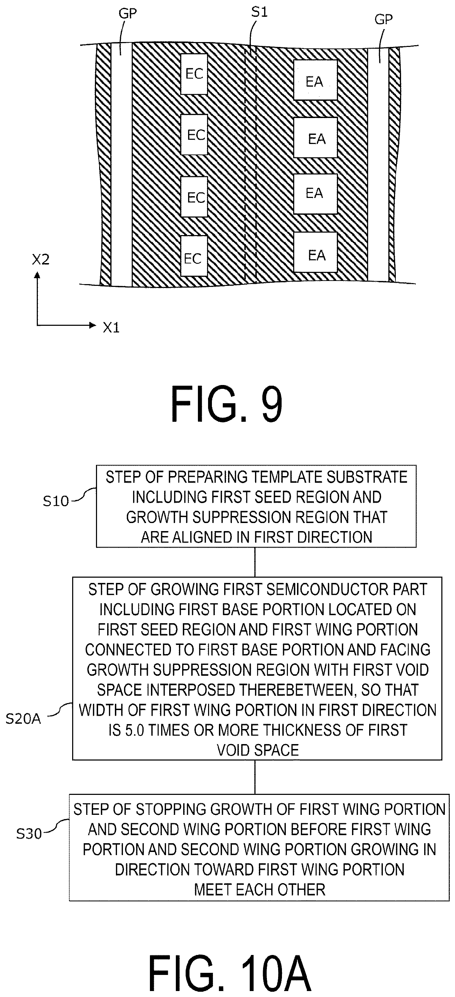

FIG. 8 is a cross-sectional view illustrating a configuration of the semiconductor substrate according to the present embodiment. FIG. 9 is a plan view illustrating a configuration of the semiconductor substrate according to the present embodiment. As illustrated in FIG. 8 and FIG. 9, the semiconductor substrate 10 may be positioned above the first semiconductor part 8A, and may be provided with an upper layer portion 9 including an active layer and a p-type layer. An anode EA and a cathode EC may be provided on the upper layer portion 9.

FIG. 10A is a flowchart showing a manufacturing method of a semiconductor substrate according to the present embodiment. The manufacturing method of a semiconductor substrate according to the present embodiment includes a step S10 of preparing the template substrate TS including the first seed region S1 and the growth suppression region DA that are aligned in the first direction X1, and a step S20 of growing the first semiconductor part 8A including the first base portion B1 located on the first seed region S1 and the first wing portion F1 connected to the first base portion B1 and facing the growth suppression region DA with the first void space J1 interposed therebetween, so that the width of the first wing portion F1 in the first direction X1 is 5.0 times or more the thickness of the first void space J1. A step S30 of stopping the growth of the first wing portion F1 and the second wing portion F2 before the first wing portion F1 and the second wing portion F2 growing in a direction approaching the first wing portion F1 meet each other may be performed. The template substrate TS may include the seed part 3 including the first seed region S1. The seed part 3 may be formed by a sputtering method.

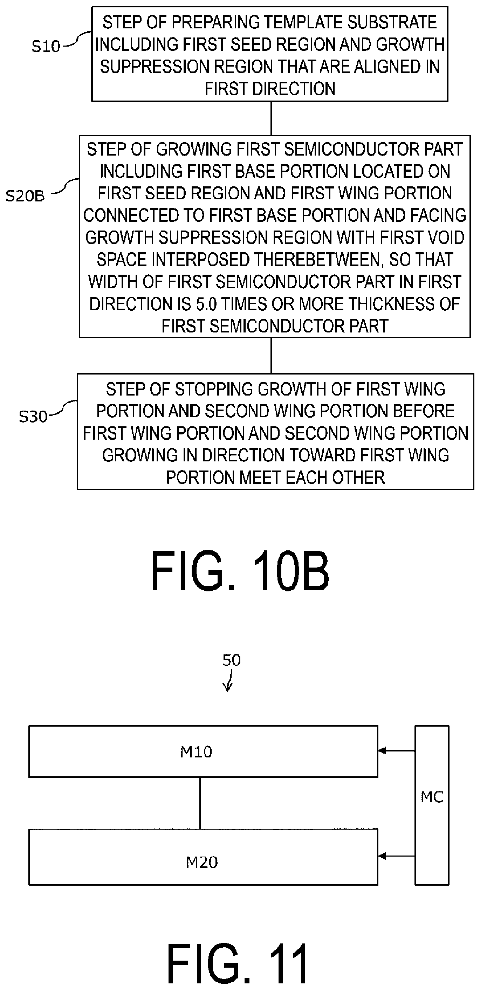

FIG. 10B is a flowchart showing a manufacturing method of a semiconductor substrate according to the present embodiment. As shown in FIG. 10B, step S10 may be followed by step S20B of growing the first semiconductor part 8A including the first base portion B1 located on the first seed region S1 and the first wing portion F1 connected to the first base portion B1 and facing the growth suppression region DA with the first void space J1 interposed therebetween, so that a width (Ws) of the first semiconductor part 8A (the entire first semiconductor part 8A including both wings) in the first direction X1 is 5.0 times or more a thickness (Th) of the first semiconductor part 8A.

FIG. 11 is a block diagram illustrating a manufacturing apparatus of a semiconductor substrate according to the present embodiment. A manufacturing apparatus 50 of a semiconductor substrate includes a device M10 that performs step S10 in FIG. 10, a device M20 that performs step S20A in FIG. 10A (step S20B in FIG. 10B), and a control device MC that controls the device M10 and the device M20. The device M20 may be an MOCVD device, and the control device MC may perform step S30 by using the device M20.

### Example 1

A silicon substrate, a silicon carbide substrate (a 4H-SiC substrate and a 6H-SiC substrate), a sapphire substrate, a nitride substrate (such as a GaN substrate and an AlN substrate), a ScMgAlO substrate, or the like can be used as the main substrate 1.

The seed part 3 is formed above the main substrate 1 and serves as a starting point from which the semiconductor part 8 grows. The seed part 3 may be formed in at least a part of the opening portion K (of the mask pattern 6), and may have a plane shape or a pattern shape (for example, a stripe shape). As the seed part 3, a GaN layer, an AlN layer, an AlGaN layer, an AlInN layer, AlGaInN, Al, or the like formed at a low temperature (a temperature equal to or lower than 500°C) may be used. The thickness of the seed part 3 is about 10 nm to 500 nm.

The buffer part 2 may be formed between the main substrate 1 and the seed part 3 (for example, a GaN layer). The buffer part 2 improves the crystallinity and the flatness of the seed part 3. The buffer part 2 may have a plane shape or a pattern shape (for example, a stripe shape) corresponding to the seed part 3. A GaN layer, an AlN layer, an AlGaN layer, an AlInN layer, AlGaInN, Al, or the like formed at a low temperature (a temperature equal to or lower than 500°C) may be used as the buffer part 2. The thickness of the buffer part 2 is about 10 nm to 500 nm. When a silicon substrate is used as the main substrate 1, it is desirable that the buffer part 2 in contact with the silicon substrate does not contain gallium in order to suppress melt back.

A layer between the main substrate 1 and the semiconductor part 8 may be referred to as an underlying layer (including the buffer part 2 and/or the seed part 3). A GaN layer may be formed as the underlying layer (for example, the seed part 3) by a sputtering method. In this case, for example, a sputtering target containing gallium nitride as a main constituent (containing gallium in an amount of 25 atm% or more) and having an oxygen content of 5 atm% or less may be used. The pressure of the sputtering gas may be less than 0.3 Pa. The sputtering method may be appropriately selected from among DC sputtering, RF sputtering, AC sputtering, DC magnetron sputtering, electron cyclotron resonance (ECR) sputtering, an RF magnetron sputtering method, a pulse sputter deposition (PSD) method, a laser ablation method, and the like.

In order to increase the crystallinity of the entire film, the sputtering target to be used may have an oxygen content of not more than 5 atm%, not more than 3 atm%, or not more than 1 atm%. The purity is also desirably as high as possible, and a content of metal impurities may be less than 0.1% or less than 0.01%. When a GaN layer is formed by a sputtering method, effects such as surface flatness, enhancement of crystallinity, and suppression of generation of surface hillocks (protrusions) can be obtained by using a gallium nitride target having a low oxygen content.

When a nitride semiconductor (such as AlN and GaN) is formed by sputtering as the underlying layer, a vacuum degree in the device before the film formation may be equal to or less than 3 * 10⁻⁵ Pa, or equal to or less than 1 * 10⁻⁵ Pa. An underlying substrate (such as a main substrate and a main substrate with a buffer) may be subjected to a pretreatment before the film formation, to remove an organic layer and/or unevenness on the surface of the underlying substrate, and thus, enabling epitaxial growth. Specific examples of the pretreatment include a reverse sputtering treatment, an acid treatment, and a UV treatment. The reverse sputtering treatment is preferable in order to avoid reattachment of impurities and the like after the treatment. The reverse sputtering treatment is a method in which atoms transformed into plasma are caused to collide with the underlying substrate to clean the surface of the underlying substrate. The temperature of the substrate during the film formation may be set to a room temperature. However, if the film is formed while the substrate is in a heated state (for example, from 400° to 1000°), the film quality can be improved.

An electrical power density during discharge may be equal to or less than 5 W/cm² or equal to or less than 1.5 W/cm². A lower limit of the electrical power density may be 0.1 W/cm² or 0.3 W/cm². The electrical power density is obtained by dividing the electrical power applied during discharge by an area of the sputtering target. When the electrical power density is too high, a raw material may be sputtered from the target in a clustered state.

In Example 1, the underlying layer (for example, the seed part) being a GaN layer was formed by an RF sputtering method. A gallium nitride target (oxygen content: 0.4 atom%) was used, a film-forming pressure was set to 0.1 Pa, and 20 to 40 sccm of nitrogen gas was introduced. Argon gas was not used in Example 1. However, needless to say, argon gas may be introduced. The discharge density was 125 W/cm², and the film-forming temperature was room temperature.

When the underlying layer (including the buffer part 2 and/or the seed part 3) is formed by using a sputtering method, a laser ablation method, or the like, an internal stress can be controlled from a compressive stress to a tensile stress by the film-forming conditions, and thus, a stress to be applied to the semiconductor part 8 can be controlled. The internal stress can also be controlled by the amount of argon introduced into the underlying layer. The stress applied to the semiconductor part 8 may be controlled by locally forming the underlying layer (in a pattern shape) on the underlying substrate.

The mask pattern 6 is formed on the base substrate by using a material that suppresses longitudinal growth (growth in the c-axis direction) of the nitride semiconductor, and thus, the mask pattern 6 enables lateral growth (for example, growth in the a-axis direction). The opening portion K (an exposed portion of the seed part 3) of the mask pattern 6 serves as a growth starting point of the semiconductor part 8. Examples of the material of the mask portion 5 of the mask pattern 6 include silicon nitride, silicon carbide, silicon carbonitride, diamond-like carbon, silicon oxide, and silicon oxynitride, titanium nitride, molybdenum nitride, tungsten nitride, and tantalum carbide, which do not contain silicon, and further metals having a high melting point (such as molybdenum, tungsten, and platinum). The mask portion 5 may be a single layer film made of one of these materials, or a multi-layer film obtained by combining a plurality of these materials. A thickness of the mask portion 5 may be about 5 nm to 2 µm.

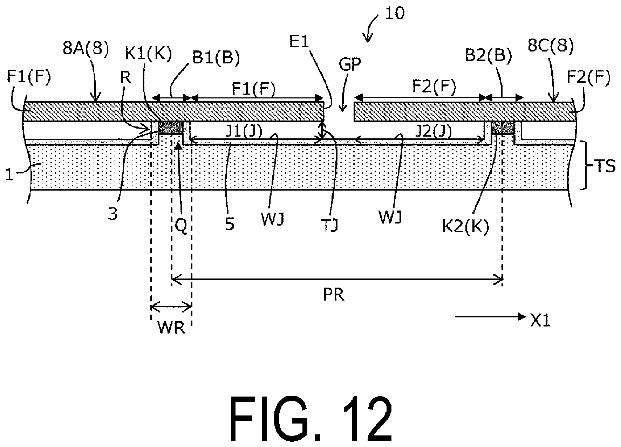

FIG. 12 is a cross-sectional view illustrating a configuration of the semiconductor substrate according to Example 1. In FIG. 12, a silicon substrate is used as the main substrate 1, and the seed part 3 is formed on a part of the upper surface of the main substrate 1. The ridge portion R including the seed part 3 and the main substrate 1 is formed in a stripe shape. The mask portion 5 is formed on the side surface of the ridge portion R and the surface of the main substrate 1. The mask pattern 6 includes the first opening portion K1 in at least a part of the upper surface of the ridge portion R. The first semiconductor part 8A is formed on the first opening portion K1, and the first void space J1 is located under the first wing portion F1. That is, the first wing portion F1 is separated from the mask portion 5 (the growth suppression region DA). The width WJ of the first void space J1 is a distance in the first direction X1 from the side surface of the ridge R to the edge E of the first semiconductor part 8A. The thickness (height) TJ of the first void space is a distance from the upper surface of the mask portion 5 to the lower surface (back surface) of the first semiconductor part 8A. A ridge width WR was 5 µm and a pitch width PR of the ridge was 55 µm.

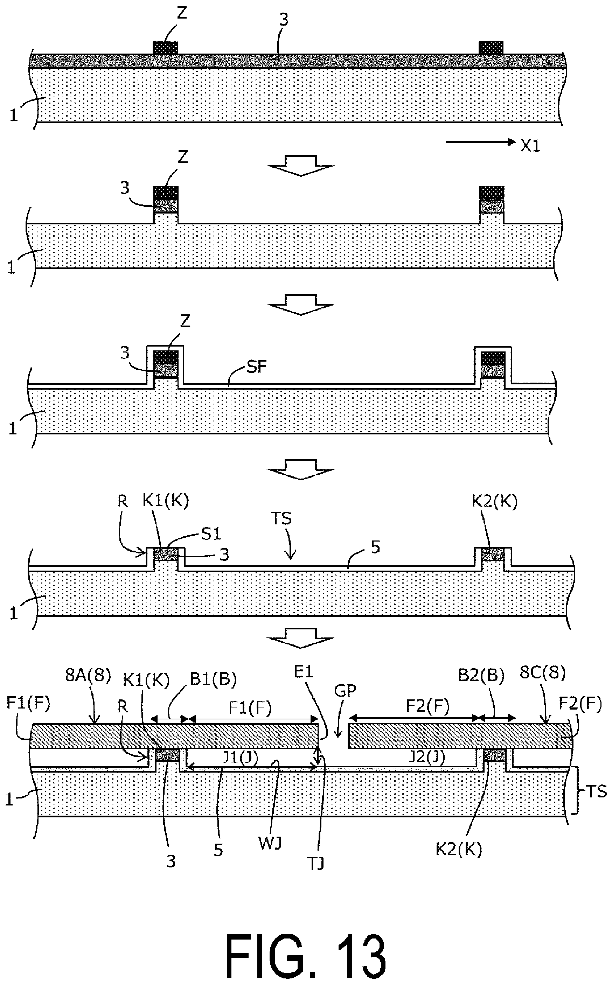

FIG. 13 is a cross-sectional view illustrating a manufacturing method of a semiconductor substrate according to Example 1. The semiconductor substrate of Example 1 can be manufactured as described below. A silicon substrate (Si (111) plane) is used as the main substrate 1, and an AlN film (the seed part 3) is formed on the silicon substrate by using a sputtering method. By using a parallel, flat plate, magnetron sputtering, pulse sputtering, or the like as the sputtering method, a film can be formed at low temperature and low cost. By using the MOCVD method, an AlN film having high crystallinity can be formed.

The thickness of the seed part 3 is 100 nm. There is a problem that silicon and gallium react with each other at high temperature (so-called melt back). In order to suppress this problem, the thickness of the seed part 3 is preferably 50 to 500 nm.

The film-forming temperature of the seed part 3 was 400°C, a mixed gas of argon gas and nitrogen gas (gas ratio of about 1:1) was used, the supplied power was 500 W, and the back pressure during film formation was 0.3 Pa. When a sapphire substrate is used, the AlN layer is directly formed. However, when an AlN layer is formed on the silicon substrate, an Al layer (the buffer part 2) having a thickness of about several nm is formed first, and then, the AlN layer is formed. Thus, an AlN layer having high quality can be formed without nitriding the silicon substrate. In the formation of the Al layer, an Al target is sputtered only with Ar gas (without introducing nitrogen). Thus, the Al layer and the AlN layer can be continuously formed, without introducing and removing the substrate into and from the same chamber. When the Al layer and the AlN layer are formed by an MOCVD device, only trimethylaluminum (TMA) may first be introduced to form an Al layer of several nm on the silicon substrate, and then, NH₃ may be introduced to obtain a laminated structure of a Si substrate/Al layer/AlN layer.

A stripe-shaped resist Z having a width of about 3 µm is formed in an upper portion of the seed part 3 by a photolithography process, and the ridge portion R is formed by a dry etching process. At this time, the seed part 3 and a part of the main substrate 1 are etched. For example, when the ridge R is formed while setting the etching thickness of the seed part 3 (AlN layer) to about 100 nm and the etching thickness of the main substrate to about 300 nm, a ridge height of about 400 nm is obtained. Here, the resist Z is not removed, and a silicon nitride film SF (for example, 10 nm) serving as the mask portion 5 is formed on the resist Z.

When the ELO layer is in contact with the mask portion (growth suppression region), the mask portion needs to have a thickness of at least 100 nm, and the mask portion and the ELO layer may interfere with each other to impair the surface flatness of the ELO layer. However, in Example 1, the wing portion F floats in midair and is not in contact with the mask portion 5, so that the growth of the wing portion F is not hindered, even if the mask portion 5 is strongly thinned. By thinning the mask portion 5, the flatness of the back surface of the wing portion F improves. Setting the thickness of the mask portion 5 to be equal to or less than 50 nm improves the flatness. The thickness thereof can be set to be equal to or less than 30 nm.

The resist Z is removed to lift off the silicon nitride film SF on the ridge portion R, and the first opening portion K1 is formed to form the template substrate TS (selective growth substrate). As described above, by manufacturing the template substrate TS without using the MOCVD method, a significant cost reduction can be realized, and the industrial advantages are very big.

When the AlN layer (underlying layer) is formed by film formation using a sputtering method, Ga does not adhere to the surface of the silicon substrate. When an AlN layer is formed by film formation using an MOCVD device used in the film formation of a GaN layer, Ga in a furnace may adhere to the surface of the silicon substrate and melt back in a temperature rising process before film formation, which causes a problem of a decrease in yield. Therefore, maintenance of the MOCVD device (for example, cleaning of components inside the device such as a tray and a cover) is frequently performed, which leads to high cost. On the other hand, the present example is a technique in which the semiconductor part 8 is formed by film formation using an MOCVD device and the AlN layer (underlying layer) and the mask layer are formed by a sputtering device different from the MOCVD device. When the silicon substrate is introduced into the MOCVD device, the surface of the silicon substrate is covered by AlN (underlying layer) and the mask portion and no decrease in yield due to melt back occurs, so that the industrial advantages are big.

The template substrate TS is conveyed into the MOCVD device, and the semiconductor part 8 is formed on the template substrate TS by an ELO method. In Example 1, the semiconductor part 8 is a GaN layer, the growth temperature is from 1000 to 1200°C, the V/III ratio is from 500 to 20000, and the growth pressure is 50 kPa. In order to obtain the semiconductor part 8 that is n-type, doping may be performed by using a flow of SiH₄. However, instead of introducing SiH₄, a material containing Si such as SiO₂ and SiN may be used for the mask portion, so that Si doping can be performed by using Si evaporated from the material. The film forming conditions are preferably set separately for at least two stages. In a first stage, a film-forming temperature is set to about 1030°C, V/III is set to about 2000, and a growth nucleus (vertical growth portion) of the ELO layer (the semiconductor part 8) is formed on the opening portion K. The thickness (height) of the growth nucleus may be about 0.2 to 3.0 µm, and the width thereof may be about the same as the width of the ridge R. Alternatively, the growth nucleus may have a size that slightly protrudes in the a-axis direction (<11-20> direction). In a second stage, the film-forming temperature was raised by about 100°C to grow the GaN layer in the lateral direction (a-axis direction) from the growth nucleus, and the growth was stopped when the width of the gap GP between semiconductor parts 8 (GaN layers) growing in opposite directions on the void space reached a specified value (10 µm or less). The semiconductor substrate 10 obtained as described above (in a state where the semiconductor part 8 is exposed) may be removed from the MOCVD device and stocked, or an upper layer portion including an active layer and the like may be subsequently formed in the MOCVD device.

In Example 1, it was found that, even if the crystallinity on the opening portion K is poor, the poor crystallinity is hardly transferred to the wing portion F on the void space (above the mask portion), and the crystallinity of the wing portion F is increased (the defect density is significantly reduced). When a nitride semiconductor layer is formed on the seed layer without using an ELO method, after the seed layer is formed by a sputtering method, defects of the seed layer are entirely transferred to the nitride semiconductor layer, so that a high-quality device cannot be obtained.

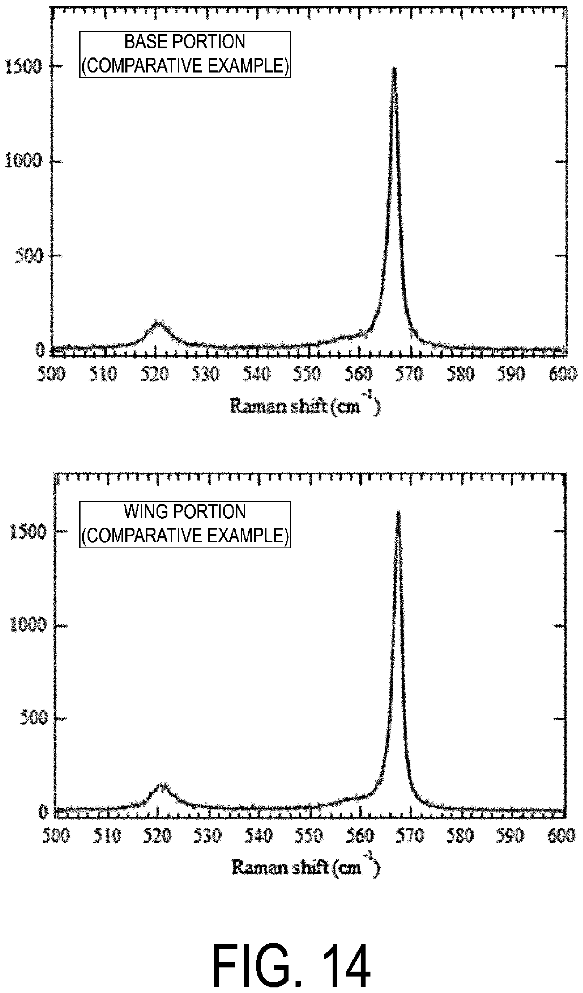

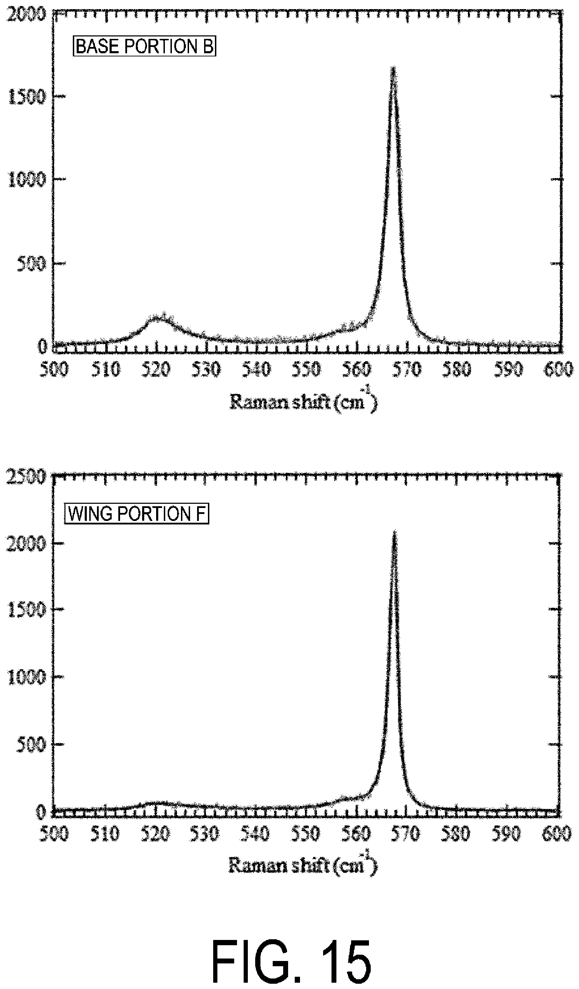

FIG. 14 illustrates Raman spectra of a base portion and a wing portion of an ELO layer according to a comparative example. The ELO layer of the comparative example is formed on the seed layer formed by the MOCVD method. FIG. 15 illustrates Raman spectra of a base portion and a wing portion of an ELO layer (a semiconductor part) according to Example 1. The seed layer is formed by a sputtering method. From FIG. 14, it can be understood that, in the comparative example, the half-value width in the spectrum of GaN in the base portion was 2.2 cm⁻¹, and the half-value width in the spectrum of GaN on the wing portion was 2.0 cm⁻¹. From FIG. 15, it was found that, in Example 1, the half-value width in the spectrum of GaN in the base portion was 2.8 cm⁻¹, the half-value width in the spectrum of GaN on the wing portion was 2.0 cm⁻¹. The wing portion consisted of a crystal having very high quality that was not different from that in the comparative example (where the seed part was formed by the MOCVD method). This is an industrially very significant discovery. This is because a high-quality semiconductor part can be obtained by using a low-cost template substrate including an inexpensive silicon substrate and an underlying portion (a seed part or a laminated portion of a buffer part and a seed part) formed by a non-MOCVD device such as a sputtering device or an EB device.

Regarding the upper layer portion 9 (the device layer, the functional layer) formed on the semiconductor part 8, by forming at least an active region (for example, a light-emitting region) above the wing portion, an element having very high quality can be manufactured. Example 1 also offers the advantage that the template substrate TS can be formed without using the MOCVD device, and the semiconductor part 8 and the upper layer portion 9 can be continuously formed by the MOCVD device.

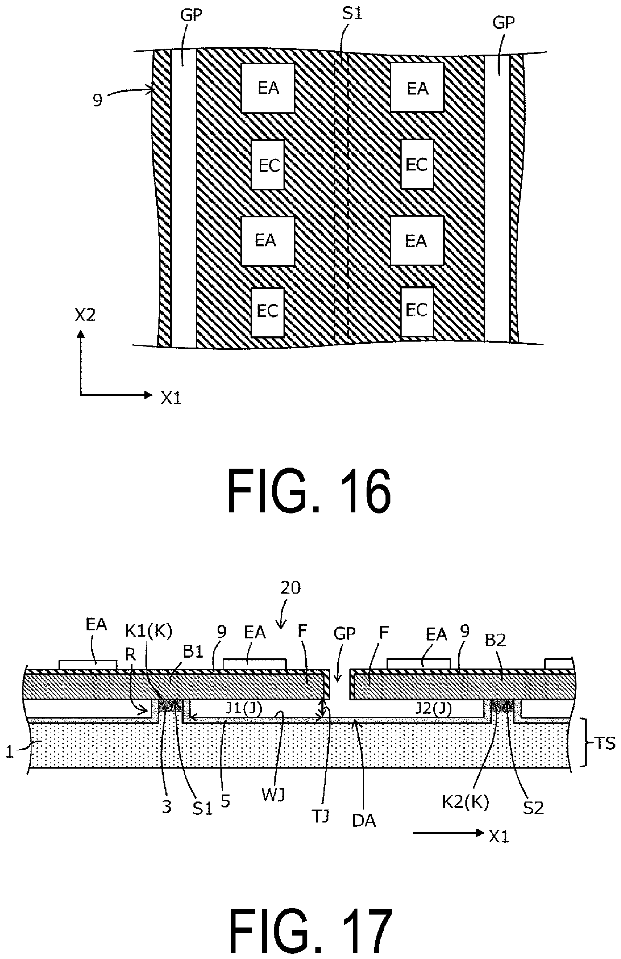

FIG. 16 is a plan view of a semiconductor substrate including an upper layer portion. FIG. 17 is a cross-sectional view of the semiconductor substrate including the upper layer portion. The upper layer portion 9 may be formed on the semiconductor part 8 by changing the film-forming conditions (for example, lowering the film-forming temperature by about 100°C) after the growth of the semiconductor part 8 is stopped. The upper layer portion 9 may include at least one selected from the group consisting of a p-type layer, an n-type layer, and an electron block layer, in addition to the active layer. Even when the upper layer portion 9 is formed on the semiconductor substrate 10, a backside overflow phenomenon in which the material of the upper layer portion is supplied to the back surface side of the semiconductor part 8 is greatly suppressed, and problems such as light absorption caused by the backside overflow phenomenon are also solved.

In the semiconductor substrate 10 illustrated in FIG. 16 and FIG. 17, an anode EA and a cathode EC are formed above the wing portion F of the semiconductor part 8. In a typical LED, an active region (light emitting region) is formed immediately below the anode EA constituted by a transparent electrode such as ITO (indium tin oxide). In Example 1, a problem that light emitted from the active region is absorbed at the back surface of the wing portion F is solved, because the backside overflow phenomenon is suppressed. At least a part of the anode EA may be located above the wing portion F, or the entire anode EA may be located above the wing portion F. The cathode EC may be formed above the ridge R because a region directly below the cathode is generally not an active region. Although the anode EA and the cathode EC are formed above the same wing portion F in FIG. 16 and FIG. 17, the configuration is not limited thereto. As illustrated in FIG. 8, the anode EA may be formed above one of the two wing portions F facing each other across the ridge portion R, and the cathode EC may be formed above the other wing portion F.

In a known ELO method, cracks may be generated in the semiconductor layer due to a difference in the thermal expansion coefficient between a heterogeneous substrate and a semiconductor layer. On the other hand, in Example 1, adjacent semiconductor parts 8 do not meet (have the gap GP) and each of the semiconductor parts 8 is located on the void space and physically separated from the mask portion 5. By these two facts, the internal stress is effectively relaxed and the occurrence of cracks is suppressed while using heterogeneous substrates (such as a Si substrate and a SiC substrate). Increasing the width of the wing portion F (for example, to 7 µm or more) can achieve stress relaxation by the wing portion F.

In Example 1, the width WJ of the void space J is 20 µm, the ridge height is 300 nm, and the width of the gap GP is 10 µm. The back surface of the semiconductor part 8 is at the same level as the upper surface of the ridge R, and thus, the thickness of the void space J is 300 nm and the aspect ratio of the void space J is 66.6. The upper layer portion 9 was formed on the semiconductor part 8. In this case, lamination of the material of the active layer and the like on the back surface of the semiconductor part 8 was not confirmed, and it was found that the backside overflow phenomenon was suppressed.

The width WR of the ridge portion R serving as the growth starting point may be from 1 µm to 20 µm, or from 2 µm to 10 µm. The thickness TJ of the void space may be 5 µm or less, 2 µm or less, 1 µm or less, 0.6 µm or less, or 0.3 µm or less. The thickness TJ of the void space may be 0.05 µm (50 nm) or greater. Thus, the mask portion 5 can be easily removed. The pitch PR of the ridge portion may be 20 µm or greater. The thickness TJ of the void space may be less than 0.5 µm (500 nm). Thus, the formation of morphology on the back surface can be reduced, and the quality of a device formed on the wing portion F can be improved. The aspect ratio of the void space J can be 5.0 or more, 10 or more, 20 or more, 30 or more, 50 or more, or 100 or more. Thus, the upper layer portion 9 can be formed on the wing portion F having a wide width, while suppressing the backside overflow phenomenon, and a semiconductor element of high quality (for example, high light extraction efficiency) can be formed. The aspect ratio of the void space J may be from 100 to 1000, for example. This reduces the risk that the semiconductor part 8 is warped in the upward direction due to gravity. By setting the width of the gap GP to 30 µm or less or 10 µm or less, the backside overflow phenomenon can be more effectively suppressed. In other words, no lamination of the material of the active layer provided at the back surface of the wing portion F formed as described above. Therefore, current leakage is unlikely to occur in the device formed on the wing portion F. The width of the gap GP may be from 1/5 to 1/100 of the width of the wing portion F. Thus, the wing portion F having a large width can be formed, while suppressing the backside overflow phenomenon, and the degree of freedom of the device can be increased.

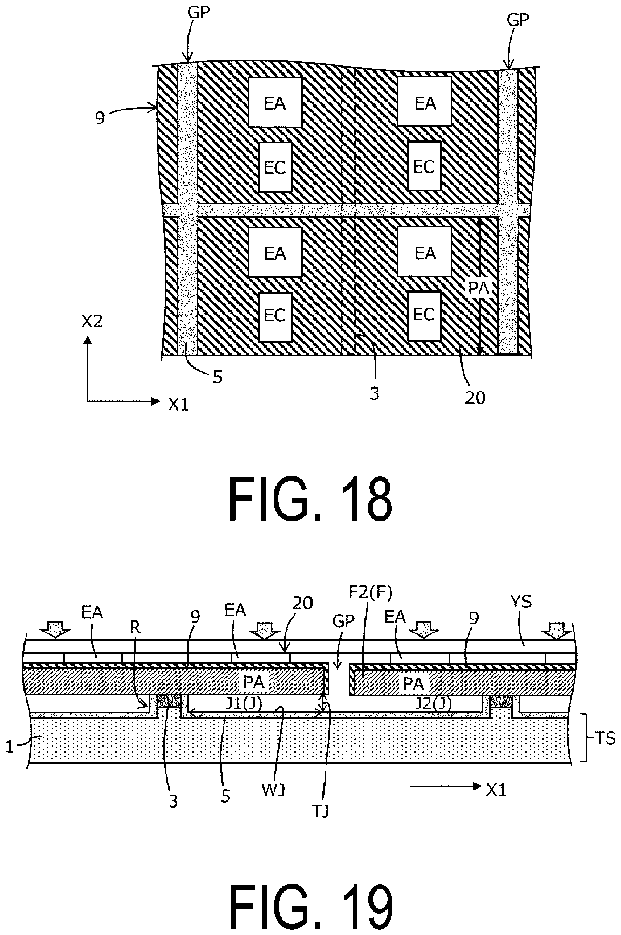

FIG. 18 is a plan view illustrating a method of element isolation in Example 1. FIG. 19 is a cross-sectional view illustrating the method of the element isolation in Example 1. As illustrated in FIG. 18 and FIG. 19, an element body 20 (including the wing portion F, the upper layer portion 9, the anode EA, and the cathode EC) is separated from the template substrate. Since the void space J under the wing portion F is present, applying a downward pressure to the element body 20 with a pressing body YS (an adhesive plate, an adhesive sheet, or the like) having an adhesive property easily breaks a root portion of the element body 20 (a portion connected to the template substrate TS), and separates the element body 20 from the template substrate TS. Specifically, the element body 20 is peeled off from the template substrate TS while being held by the pressing body YS. As described above, the void space J effectively functions also in the separation of the element body, and the element body 20 can be peeled off without damaging the element body 20.

Specific examples of the element body 20 include a light emitting diode (LED), a semiconductor laser, a Schottky diode, a photodiode, and transistors (including a power transistor and a high electron mobility transistor).

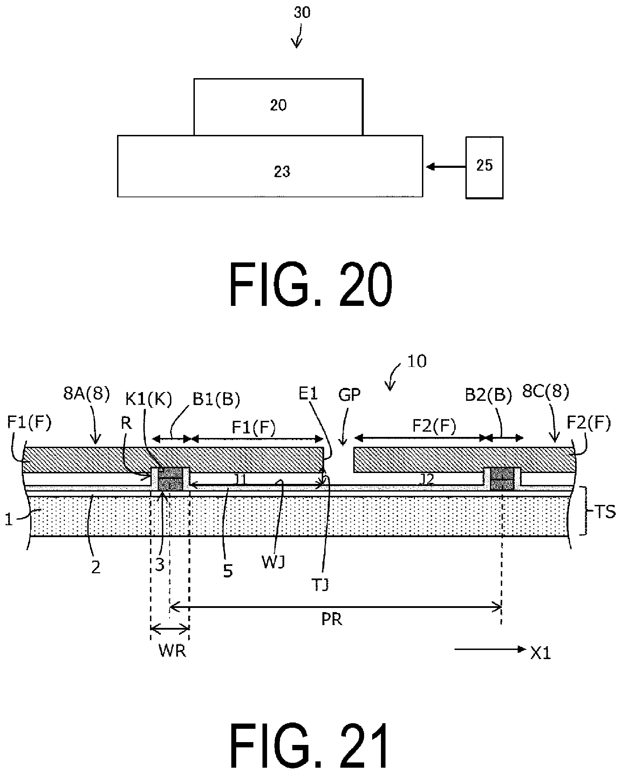

FIG. 20 is a schematic view illustrating a configuration of an electronic device according to Example 1. An electronic device 30 includes the element body 20, a drive substrate 23 to which the element body 20 is mounted, and a control circuit 25 that controls the drive substrate 23. The control circuit 25 may include a processor. Examples of the electronic device 30 include display devices, laser emitting devices (including a Fabry-Perot device and a surface light emitting device), lighting devices, communication apparatuses, information processing devices, sensing devices, and electrical power control devices.

In FIG. 20, the element body 20 is bonded and electrically connected to the drive substrate 23 while being peeled off from the template substrate TS, but may be bonded and electrically connected to the drive substrate 23 while not being peeled off (the template substrate TS and the element body 20 thereon).

### Example 2

In Example 2, the semiconductor substrate 10 in FIG. 3 was formed. Specifically, a silicon substrate is used as the main substrate 1, an Al layer (not illustrated) having a thickness of 3 nm is formed on the main substrate 1, and then, an AlN layer having a thickness of 200 nm is formed by film formation as the buffer part 2 by using a sputtering method. The film-forming temperature is 400°C, and a mixed gas of argon gas and nitrogen gas is used. The gas ratio was about 1:1, the supplied electrical power was 500 W, and the back pressure during film formation was 0.3 Pa. A GaN layer having a thickness of 400 nm and serving as the seed part 3 was formed by film formation on the buffer part 2 (AlN layer) by a sputtering method using a GaN target. Afterwards, the ridge portion R and the SiN film were formed by the above-described method, and the SiN film on the ridge portion was lifted off to obtain the template substrate TS (selective growth substrate) including the mask pattern 6. A bottom surface of the ridge portion R extends to the main substrate 1, and the main substrate 1 is embedded to about 400 nm therein. Subsequently, the semiconductor part 8 was formed on the template substrate TS by using the MOCVD method, and thus, the semiconductor substrate 10 was obtained.

In Example 2, the height of the ridge portion R can be calculated as follows. 200 nm (the thickness of the AlN layer) + 400 nm (the thickness of the GaN layer) + 400nm (the embedded depth of the main substrate) = 1000 nm (1.0 µm). The width of the ridge portion R was 3 µm, the pitch width of the ridge portion was 40 µm, the width of the gap GP was 5 µm, and the width WJ of the void space J was 16 µm. The upper surface of the ridge portion R and the back surface of the semiconductor part 8 were at the same height, and thus, the thickness TJ of the void space J was 1 µm and the aspect ratio of the void space J was 16.0.

In Example 2, by changing the film-forming conditions in the ELO method (for example, by changing the partial pressures of nitrogen and hydrogen in the gas flow and increasing the amount of hydrogen), the configuration illustrated in FIG. 4 in which the height of the back surface of the wing portion F is lower than the upper surface of the ridge portion R can be obtained. In this case, the film formation was completed at a position where the back surface of the wing portion F was lower than the upper surface of the ridge portion R by about 600 nm, and the thickness TJ of the void space J was 400 nm. The width of the ridge portion R was 8 µm, the pitch width of the ridge portion was 78 µm, and the width of the gap GP was 30 µm. Therefore, the width WJ of the void space J was 20 µm, and the aspect ratio of the void space J was 50.

### Example 3

In Example 3, the semiconductor substrate 10 in FIG. 2 was formed. Specifically, a sapphire substrate is used as the main substrate 1, and an AlN layer having a thickness of 200 nm is formed by film formation as the seed part 3 on the main substrate 1 by using a sputtering method. The film-forming temperature is 500°C, and a mixed gas of argon gas and nitrogen gas is used. The gas ratio was about 1:1, the supplied electrical power was 500 W, and the back pressure during film formation was 0.3 Pa. Afterwards, the ridge portion R and the SiN film were formed by the above-described method, and the SiN film on the ridge portion was lifted off to obtain the template substrate TS (selective growth substrate) including the mask pattern 6. The bottom surface of the ridge portion R extends to the main substrate 1 (sapphire substrate), and the main substrate 1 is embedded to about 10 nm therein. Afterwards, the semiconductor part 8 was formed on the template substrate TS by using the MOCVD method.

In Example 3, the height of the ridge portion R can be calculated as follows. 200 nm (the thickness of the AlN layer) + 10 nm (the embedded depth of the main substrate) = 210 nm. The width of the ridge portion R was 2 µm, the pitch width of the ridge portion was 30 µm, the width of the gap GP was 2 µm, and the width WJ of the void space J was 13 µm. The upper surface of the ridge portion R and the back surface of the semiconductor part 8 were at the same height, and thus, the thickness TJ of the void space J was 200 nm and the aspect ratio of the void space J was 65. The upper layer portion 9 was formed on the semiconductor part 8. In this case, lamination of the material of the active layer and the like on the back surface of the semiconductor part 8 was not confirmed, and it was found that the backside overflow phenomenon was suppressed.

### Example 4

FIG. 21 is a cross-sectional view illustrating a configuration of a semiconductor substrate according to Example 4. In Example 4, in the template substrate TS, the seed part 3 having a two-layer structure including an AlGaN layer (2 µm) and a GaN layer (1.5 µm) was formed by an MOCVD method on the AlN layer (200 nm) serving as the buffer part 2. The height of the ridge portion R is 300 nm, and the bottom surface of the ridge portion R is within the GaN layer (the bottom layer of the seed part 3). The semiconductor part 8 was formed on the template substrate TS by using the MOCVD method.

In Example 4, the width WR of the ridge portion R was 3 µm, the pitch width PR of the ridge portion was 55 µm, the width of the gap GP was 10 µm, and the width WJ of the void space J was 21 µm. The back surface of the wing portion F was lower than the upper surface of the ridge portion R by about 50 nm and the thickness TJ of the void portion J was 250 nm, so that the aspect ratio of the void portion J was 84.

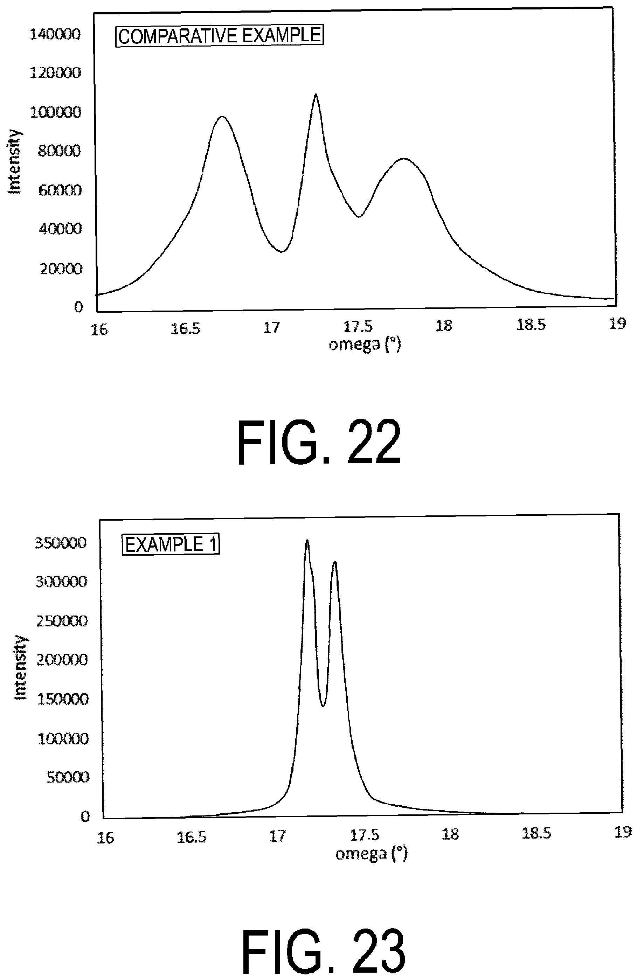

FIG. 22 is a graph showing a result of XRD reflection scan measurement for the ELO layer according to the comparative example. The ELO layer of the comparative example was grown in the lateral direction so as to contact the mask portion. FIG. 23 is a graph showing a result of XRD reflection scan measurement for the semiconductor part according to Example 1. In FIG. 22, three peaks corresponding to the base portion and two wing portions (a pair of wing portions) sandwiching the base portion are detected. The central peak is the peak of the base, and the crystal axis of the c-plane (c-axis) is substantially perpendicular to the surface of the mask portion. In FIG. 22, an angular difference Δ between the peaks of the two wing portions was 1.1 degrees. From these results, it can be seen that, in the comparative example, the c-axes of both wing portions are shifted from the center to opposite sides by about 0.5 degrees. Such an inclination of the c-axis indicates low flatness of the ELO layer. On the other hand, in FIG. 23, the angular difference Δ between the peaks of the two wing portions was 0.17 degrees, which was 1/5 or less of the comparative example. From these results, it can be understood that, in Example 1, the flatness of the semiconductor part 8 is significantly improved, compared to the comparative example. Also in other examples, a value of Δ = 0.2 degrees or less was obtained. The reason therefor is considered to be that the wing portions F are grown on the void space J and the gap GP is formed without adjacent ones of the semiconductor parts 8 meeting each other. As such excellent flatness is obtained in the wing portion F having a wide width (for example, 7 µm or more), indium (In) is uniformly incorporated in the plane in the formation of the upper layer portion 9 (for example, see FIG. 17), and the quality (for example, light emission efficiency) and yield of the element body 20 were significantly improved.

### Example 5

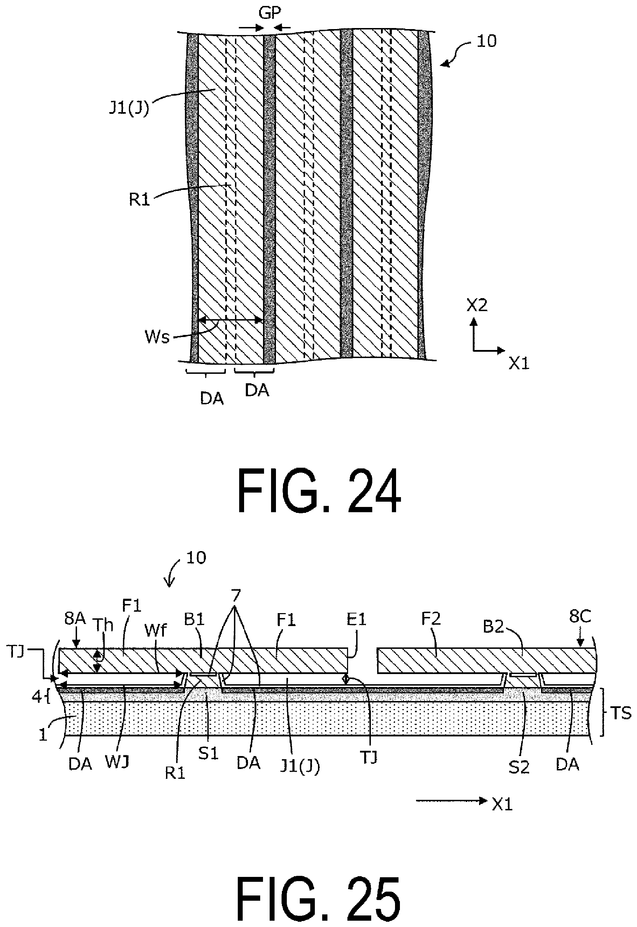

FIG. 24 is a plan view illustrating a configuration of a semiconductor substrate according to Example 5. FIG. 24 is a cross-sectional view illustrating a configuration of the semiconductor substrate according to Example 5. As illustrated in FIGs. 24 and 25, a semiconductor substrate includes the template substrate TS and the first semiconductor part 8A. The template substrate TS includes the first seed region S1 and the growth suppression region (non-seed part) DA aligned in the first direction X1. The first semiconductor part 8A is located above the template substrate TS and includes the first base portion B1 located above the first seed region S1 and the first wing portion F1 connected to the first base portion B1 and facing the growth suppression region DA via the first void space J1. The first wing portion F1 includes the wing end (edge) E1 located above the growth suppression region DA. A ratio of the width of the first void space J1 in the first direction X1 with respect to the thickness TJ is 5.0 or more. According to such a configuration, a device layer (functional layer) having a large width can be formed on the first wing portion F1. The thickness TJ of the first void space J1 may be the thickness of the first void space J1 below the wing end E1.

In the semiconductor substrate 10, the template substrate TS includes the main substrate 1 and the underlying layer 4. The underlying layer 4 is unmodified in the first seed region S1, and the underlying layer 4 is modified in the growth suppression region DA. The first semiconductor part 8A includes the first raised portion R1 located on the first seed region S1, and a growth suppression film 7 in contact with the first raised portion R1 is provided. The first raised portion R1 is in contact with the first base portion B1 formed in a mesa shape on the first seed region S1. The growth suppression film 7 may be in contact with a side surface and an upper surface of the first raised portion R1, or may be located on the growth suppression region DA.

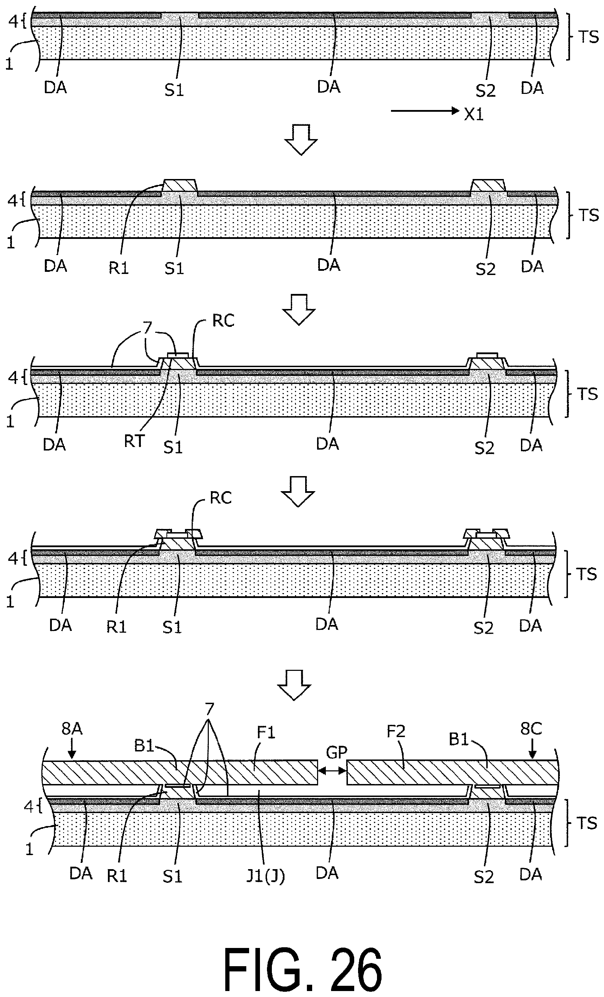

FIG. 26 is a cross-sectional view illustrating a method of manufacturing the semiconductor substrate in FIG. 25. FIG. 26 includes a step of preparing the template substrate TS including the first seed region S1 and the growth suppression region DA, a step of forming the first raised portion R1 from the first region S1 above the template substrate TS, a step of forming the growth suppression film 7 in contact with the first raised portion R1, and a step of forming the first base portion B1 located above the first raised portion R1, and the first wing portion F1 that is connected to the first base portion B 1, separated from the growth suppression region DA, and located above the void space J1.

As illustrated in FIG. 26, the first base portion B1 and the first wing portion F1 may be formed with a corner portion RC of the first raised portion R1 as a growth starting point. As described above, the corner portion RC may be used as a growth starting point. However, the configuration is not limited thereto. A defect portion (for example, a small opening) may be formed in the growth suppression film 7 on the first raised portion R1, and the defect portion of the growth suppression film 7 may be used as a growth starting point of the first base portion B1 and the first wing portion F1.

The first raised portion R1, the growth suppression film 7, the first base portion B1, and the first wing portion F1 may be continuously formed by using a metal organic chemical vapor deposition (MOCVD) device. The first raised portion R1 includes a GaN-based semiconductor. The growth suppression film 7 includes silicon nitride. The first raised portion R1 may be formed by supplying a raw material serving as a gallium source (organic materials such as trimethylgallium (TMG) and triethylgallium (TEG)) and a raw material serving as a nitrogen source (ammonia gas (NH₃)). The growth suppression film 7 may be formed by stopping the supply of the raw material serving as the gallium source and supplying a silicon-based material (for example, SiH₄), while maintaining the supply of the raw material serving as the nitrogen source. The first base portion B1 and the first wing portion F1 may include a GaN-based semiconductor. The first base portion B1 and the first wing portion F1 may be formed by stopping the supply of the silicon-based material and supplying the raw material serving as a gallium source, while maintaining the supply of the raw material serving as a nitrogen source. A small amount of the silicon-based material may be continuously supplied at the doping level. The first raised portion R1 is made of the same GaN-based semiconductor as the first wing portion F1, and thus, the lattice defects resulting from a difference in lattice constants between the first raised portion R1 and the first wing portion F1 are reduced.

By forming the growth suppression film 7 as described above, film formation can be continuously performed, while forming the first void space J1 under the wing portion F, without removing the product from the MOCVD device, and the manufacturing time and the manufacturing cost can be reduced. By forming the first void space J1 and forming the wing portion F so as not to be in contact with the underlying layer 4 (the growth suppression region DA), the stress or the like applied to the semiconductor part 8 from the main substrate 1 and the underlying layer 4 can be effectively relaxed.

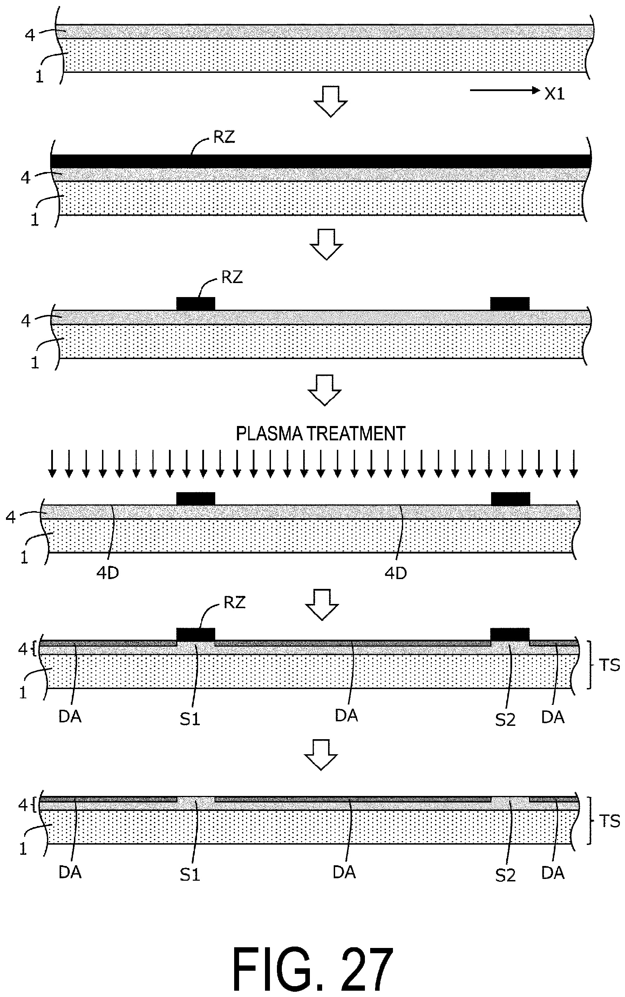

FIG. 27 is a cross-sectional view illustrating a method of manufacturing the template substrate in FIG. 25. As illustrated in FIG. 27, the template substrate TS of FIG. 25 may be obtained by performing a step of forming the underlying layer 4 including an underlying material, a step of forming a resist RZ by film formation on the underlying layer 4, a step of patterning the resist RZ, a step of subjecting the exposed underlying material to a plasma treatment, and a step of removing the resist RZ. The underlying layer 4 may be formed by a sputtering method.

For example, in the plasma treatment, an exposed surface 4D of the underlying layer 4 is irradiated with an argon plasma to modify the surface of the irradiated regions, and form the growth suppression region DA. By introducing not only argon gas, but also oxygen gas, nitrogen gas, hydrogen gas or the like into the chamber, an oxygen plasma, a nitrogen plasma, a hydrogen plasma, or a mixed plasma of these plasma types can be used in the plasma treatment, in addition to the argon plasma. Thus, the growth suppression region DA may contain argon, oxygen, nitrogen, or the like as an impurity. In such a case, the underlying material may be aluminum nitride and the growth suppression region DA may include aluminum oxynitride. The underlying material may be aluminum scandium nitride (AlScN) and the growth suppression region DA may include aluminum scandium oxynitride (AlScON).

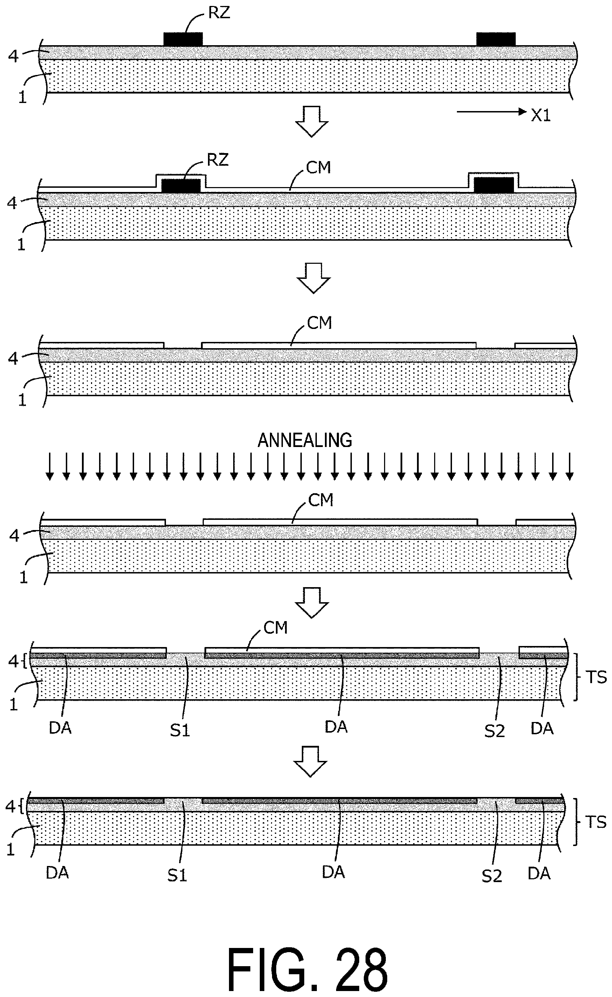

FIG. 28 is a cross-sectional view illustrating a method of manufacturing a template substrate. As illustrated in FIG. 28, the following steps may be performed: a step of forming the resist RZ by patterning on the underlying layer 4 (for example, an AlN layer), a step of forming a coating film CM (for example, a silicon nitride film of about 10 nm) covering the underlying layer 4 and the resist RZ, a step of removing the resist RZ (lift-off patterning of the coating film CM), a step of annealing the coating film CM and the underlying layer 4 (for example, by a thermal treatment at 1000°C), and a step of removing the coating film CM (for example, removing the silicon nitride film with buffered HF (BHF)). Thus, the growth suppression region DA located under the coating film CM can be formed on the surface of the underlying layer 4 by a mutual diffusion phenomenon between the underlying layer 4 and the coating film CM during annealing. By forming the coating film CM by sputtering, the surface under the coating film CM can be modified, without implementing the annealing treatment. The underlying material may contain different materials (for example, a metal element other than a group III metal element) such as scandium (Sc), Zn, and Cr, and the underlying material may be AlScN, ScN, ZnO, CrN, and the like. The underlying layer 4 may have a single-layer structure or a multi-layer structure. The multi-layer structure may include a periodic structure.

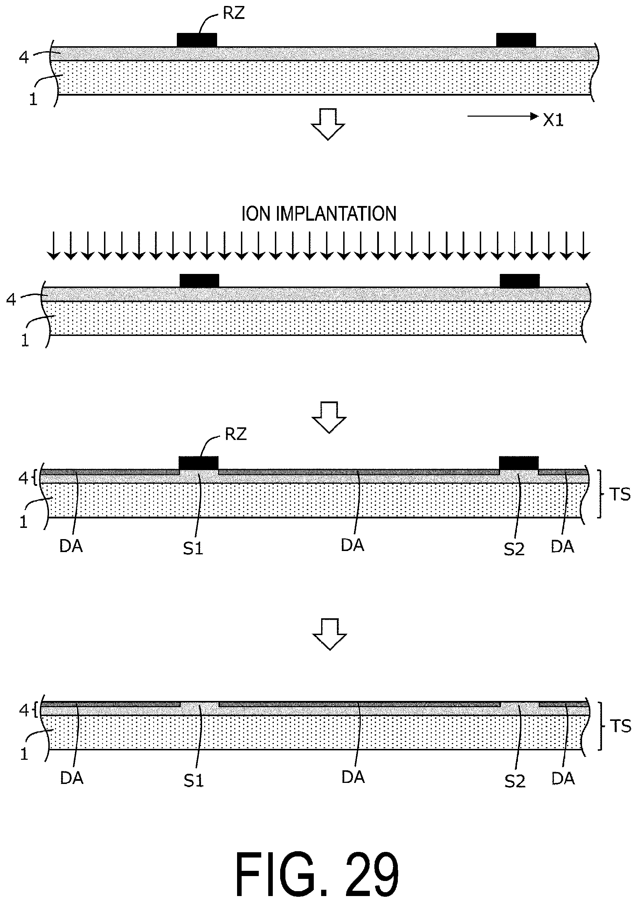

FIG. 29 is a cross-sectional view illustrating a method of manufacturing a template substrate. As illustrated in FIG. 29, a step of forming the resist RZ by patterning on the underlying layer 4 (for example, an AlN layer), a step of subjecting the exposed underlying material to an impurity ion implantation treatment, and a step of removing the resist RZ may be performed. Examples of the impurities include silicon (Si), iron (Fe), and magnesium (Mg). In the implantation treatment, impurity ions are implanted into the exposed surface 4D of the underlying layer 4 to modify the surface, and thus, the growth suppression region DA is formed. The underlying material may contain different materials (for example, a metal element other than a group III metal element) such as scandium (Sc), Zn, and Cr, and the underlying material may be AlScN, ScN, ZnO, CrN, and the like. The underlying layer 4 may have a single-layer structure or a multi-layer structure. The multi-layer structure may include a periodic structure.

### Example 6

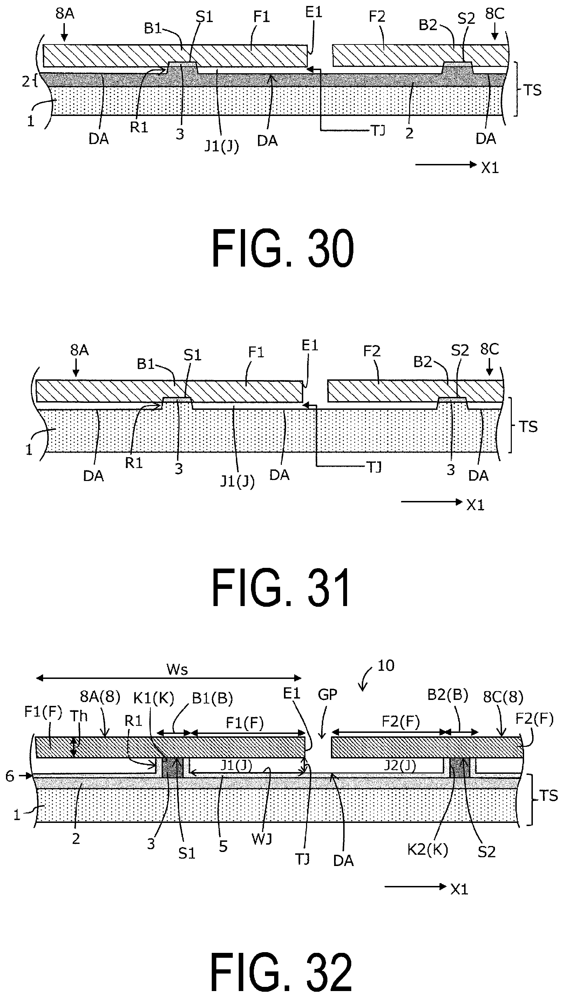

FIGs. 30 and 31 are cross-sectional views each illustrating a configuration of a semiconductor substrate according to Example 6. As illustrated in FIGs. 30 and 31, a semiconductor substrate includes the template substrate TS and the first semiconductor part 8A. The template substrate TS includes the first seed region S1 and the growth suppression region (non-seed part) DA aligned in the first direction X1. The first semiconductor part 8A is located above the template substrate TS and includes the first base portion B1 located above the first seed region S1 and the first wing portion F1 connected to the first base portion B1 and facing the growth suppression region DA via the first void space J1. The first wing portion F1 includes the wing end (edge) E1 located above the growth suppression region DA. A ratio of the width (WJ) of the first void space J1 in the first direction X1 with respect to the thickness TJ is 5.0 or more. The width (width Wf of one wing) of the first wing portion F1 in the first direction X1 may be equal to or greater than 5.0 times the thickness TJ of the first void space J1. The thickness TJ may be a thickness of the first void space J1 below the wing end E1, or may be a distance (interval) from the growth suppression region DA to the wing end E1. According to such a configuration, a device layer (upper layer portion, functional layer) having a large width can be formed on the first wing portion F1. The first wing portion F1 may have a threading dislocation density of not more than 5 * 10⁶ dislocations/cm². The first wing portion F1 may have a ratio of a width (width Wf of one wing) in the first direction X1 with respect to the thickness Th (wing thickness) of 5.0 or more.

The template substrate TS in FIG. 30 includes the main substrate 1, the buffer part (a planar buffer layer) 2, and the seed part 3. The buffer part 2 is a growth suppression layer (layer that suppresses the growth of the nitride semiconductor crystal) and includes the ridge portion (protruding portion) R1. The buffer part 2 may include at least one selected from the group consisting of a 4H-SiC layer, a 6H-SiC layer, a 3C-SiC layer, a sapphire layer, a diamond layer, and an ScAlMgO layer. The seed part 3 (for example, AlN) including the first seed region S1 is formed on the ridge portion R1, and a region of the upper surface of the buffer part 2 that does not overlap with the seed part 3 functions as the growth suppression region DA. A silicon substrate, a silicon carbide substrate, a sapphire substrate, and the like can be used as the main substrate 1.

The template substrate TS in FIG. 31 includes the main substrate 1 and the seed part 3. The main substrate 1 is a growth suppression substrate (a substrate that suppresses growth of the nitride semiconductor crystal) and includes the ridge portion (protruding portion) R1. The main substrate 1 may be a 4H-SiC substrate, a 6H-SiC substrate, a 3C-SiC substrate, a sapphire substrate, a diamond substrate, or an ScAlMgO substrate. The seed part 3 (for example, AlN) including the first seed region S1 is formed on the ridge portion R1, and a region of the upper surface of the main substrate 1 that does not overlap with the seed part 3 functions as the growth suppression region DA.

### Example 7

FIG. 32 is a cross-sectional view illustrating a configuration of a semiconductor substrate according to Example 7. The semiconductor substrate 10 in FIG. 32 includes the template substrate TS including the first seed region S1, and the first semiconductor part 8 located above the template substrate TS. The first semiconductor part 8 includes the first base portion B1 located on the first seed region S1, and the first wing portion F1 adjacent to the first base portion B1 in the first direction X1 and connected to the first base portion B1. The template substrate TS includes the growth suppression region DA facing the first wing portion F1 via the first void space J1. The first wing portion F1 includes the wing end (edge) E1 located above the growth suppression region DA. The ratio of the length WJ of the first void space J1 in the first direction X1 with respect to the thickness TJ of the first void portion J1 is equal to or greater than 5.0.

The template substrate TS includes the main substrate 1 having a different lattice constant from the first semiconductor part 8, and the seed part 3 located above the main substrate 1. The upper surface of the seed part 3 may be the first seed region S1, and the side surface of the seed part 3 may be covered with the same material as that of the growth suppression region DA.

As illustrated in FIG. 32, the buffer part 2 having a flat shape (for example, a planar AlN layer) may be formed on the main substrate 1, and the seed part 3 (ridge portion R1) having a mesa shape and including the first seed region S1 may be formed on the buffer part 2. The seed part 3 may be a GaN-based semiconductor. By using the same GaN-based semiconductor for the seed part 3 and the first semiconductor part 8, lattice defects caused by a difference in lattice constants between the seed part 3 and the first semiconductor part 8 are reduced. In the example illustrated in FIG. 32, the thickness TJ of the first void space J1 under the wing end is 482 nm, the width of the first void space J1 is 20.1 µm, the width of the opening K is 3.06 µm, the width (length in the first direction) Ws of the entire first semiconductor part 8 including both wings is 44.1 µm, and the width (wing width) Th of the first semiconductor part 8 is 2.22 µm. Regarding the thickness of the first void space J1, the thickness under the wing roots may be different from the thickness under the wing ends by about 0 to 5%. In this case, the thickness of the first void space J1 may be the thickness (TJ) under the wing ends or may be the minimum thickness over the entire first void space J1.

### Example 8

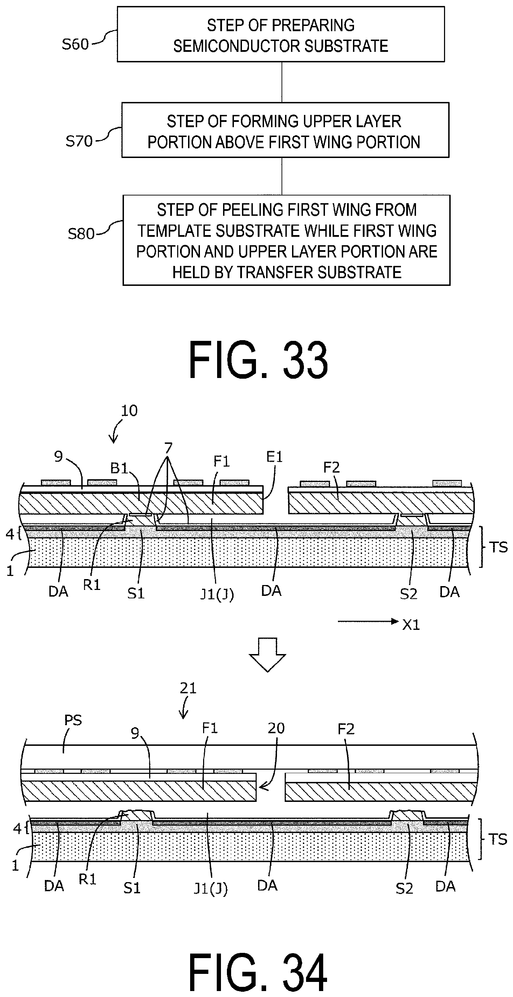

FIG. 33 is a flowchart showing a method of manufacturing a semiconductor device according to Example 8. FIG. 34 is a cross-sectional view illustrating a method of manufacturing the semiconductor device according to Example 8. As illustrated in FIGs. 33 and 34, a step S60 of preparing the semiconductor substrate 10, a step S70 of forming the upper layer portion 9 above the first wing portion F1, and a step S80 of peeling the first wing F1 from the template substrate TS while the first wing portion F1 and the upper layer portion 9 are held by a transfer substrate PS may be performed to obtain the element body 20 (semiconductor device) and the semiconductor device 21 including the element body 20 and the transfer substrate PS. In step S70, the upper layer portion 9 may not be formed below (on the back surface of) the first wing F1. For example, the upper layer portion 9 (functional layer) may be a nitride semiconductor layer (such as a GaN-based semiconductor layer) including an active layer. An electrode, an insulating film, and the like may be provided on the upper layer portion 9. The semiconductor device (20, 21) may include an electrode, and an insulating film.

In the semiconductor substrate 10 of FIG. 35, the growth suppression film 7 is located on the first raised portion R1, and thus, the bond between the first raised portion R1 and the first wing portion F1 is weak, and the first wing portion F1 can be easily peeled off. The first raised portion R1 and the first base portion B1 are made of nitride semiconductor crystals and thus, cleavage may be performed at a boundary between the first raised portion SL and the first base portion B1.

### Supplement

The foregoing disclosure has been presented for purposes of illustration and description, and not limitation. It is noted that many variations will be apparent to those skilled in the art based on these illustrations and descriptions, and these variations are also included in the embodiments.

### REFERENCE SIGNS

1 Main substrate
2 Buffer part
3 Seed part
4 Underlying layer
5 Mask portion
6 Mask pattern
8A First semiconductor part
8C Second semiconductor part
9 Upper layer portion
10 Semiconductor substrate
20 Element body (semiconductor device)
21 Semiconductor device
50 Manufacturing apparatus of semiconductor substrate
R Ridge portion
E1 Edge
B1 First base portion
B2 Second base portion
F1 First wing portion
F2 Second wing portion
J1 First void space
J2 Second void space
S1 First seed region
S2 Second seed region
DA Growth suppression region
TS Template substrate

## Claims

1. A semiconductor substrate comprising:
a template substrate comprising a first seed region and a growth suppression region aligned in a first direction; and
a first semiconductor part located above the template substrate, wherein
the first semiconductor part comprises:
a first base portion located on the first seed region; and
a first wing portion connected to the first base portion and facing the growth suppression region via a first void space,
the first wing portion comprises a wing end located above the growth suppression region, and
in the first void space, a ratio of a width in the first direction with respect to a thickness under the wing end is 5.0 or more.

2. The semiconductor substrate according to claim 1, wherein
in the first wing portion, a ratio of the width in the first direction with respect to a thickness is 5.0 or more.

3. The semiconductor substrate according to claim 1 or 2, wherein
the width of the first wing portion in the first direction is 7.0 µm or more.

4. The semiconductor substrate according to any one of claims 1 to 3, further comprising:
a second semiconductor part located above the template substrate, wherein
the template substrate comprises a second seed region adjacent to the first seed region with the growth suppression region interposed between the first seed region and the second seed region in a plan view,
the second seed region is located above the growth suppression region,
the second semiconductor part comprises:
a second base portion located on the second seed region; and
a second wing portion connected to the second base portion and facing the growth suppression region with a second void space interposed between the growth suppression region and the second wing portion,
the second wing portion comprising a wing end located above the growth suppression region,
the first wing portion and the second wing portion are aligned in the first direction with a gap interposed between the first wing portion and the second wing portion, and
in the second void space, a ratio of a width in the first direction with respect to a thickness below the wing end is 5.0 or more.

5. The semiconductor substrate according to claim 4, wherein
a width of the gap is greater than the thickness of the first void space under the wing end.

6. The semiconductor substrate according to any one of claims 1 to 5, wherein
the template substrate comprises a ridge portion on an upper surface side, and
the first seed region is located on an upper surface of the ridge portion.

7. The semiconductor substrate according to any one of claims 1 to 6, wherein
a ratio of a width of the first wing portion with respect to a width of the first base is equal to or greater than 3.0.

8. The semiconductor substrate according to any one of claims 1 to 7, wherein
a thickness of the first wing portion and a thickness of the first base are the same.

9. The semiconductor substrate according to any one of claims 1 to 7, wherein
a thickness of the first wing portion is greater than a thickness of the first base.

10. The semiconductor substrate according to any one of claims 1 to 9, wherein
the thickness of the first void space under the wing end is equal to or smaller than 3.0 µm.

11. The semiconductor substrate according to any one of claims 1 to 10, wherein
each of the first seed region and the growth suppression region has a shape having a longitudinal direction in a second direction orthogonal to the first direction.

12. The semiconductor substrate according to any one of claims 1 to 11, wherein
the template substrate comprises
a main substrate having a lattice constant different from a lattice constant of the first semiconductor part, and
a seed part.

13. The semiconductor substrate according to claim 12, wherein
the main substrate is a silicon substrate, a sapphire substrate, or a silicon carbide substrate, and
the first semiconductor part comprises a nitride semiconductor.

14. The semiconductor substrate according to claim 12 or 13, wherein
the template substrate comprises
a mask pattern comprising a mask portion functioning as the growth suppression region, and an opening portion functioning as the first seed region.

15. The semiconductor substrate according to claim 14, wherein
the template substrate comprises a ridge portion on an upper surface side, and
the ridge portion comprises the seed part.

16. The semiconductor substrate according to claim 15, wherein
the seed part is not disposed under the mask portion.

17. The semiconductor substrate according to claim 15 or 16, wherein
an upper surface of the ridge portion is constituted of the seed part, and a side surface of the ridge portion is constituted of the mask portion.

18. The semiconductor substrate according to any one of claims 15 to 17, wherein
the main substrate comprises a protruding portion on an upper surface side, and the seed part is located on the protruding portion.

19. The semiconductor substrate according to any one of claims 15 to 17, wherein
the ridge portion is located above an upper surface of the main substrate, which is flat.

20. The semiconductor substrate according to claim 17, wherein
the side surface of the ridge portion is not in contact with the first wing portion.

21. The semiconductor substrate according to claim 17, wherein
the side surface of the ridge portion is in contact with the first wing portion.

22. The semiconductor substrate according to any one of claims 14 to 21, wherein
a thickness of the mask portion is equal to or less than 50 nm.

23. The semiconductor substrate according to any one of claims 12 to 22, wherein
the seed part is made of a nitride semiconductor containing argon or oxygen at 2 × 10¹⁸/cm³ or more.

24. The semiconductor substrate according to claim 13, wherein
the nitride semiconductor is a GaN-based semiconductor, and
in the first void space, a ratio of the width with respect to the thickness is 20.0 or more.

25. The semiconductor substrate according to claim 11, wherein
the first wing portion is divided into a plurality of parts aligned in a second direction orthogonal to the first direction.

26. The semiconductor substrate according to any one of claims 1 to 25, wherein
the first semiconductor part comprises a pair of first wing portions extending from the first base in the first direction and in a direction opposite to the first direction.

27. The semiconductor substrate according to any one of claims 1 to 26, further comprising:
an upper layer portion positioned above the first semiconductor part, the upper layer portion comprising an active layer and a p-type layer.

28. The semiconductor substrate according to any one of claims 1 to 27, wherein
the first semiconductor part comprises a raised portion located on the first seed region, and
a growth suppression film in contact with the raised portion is provided.

29. The semiconductor substrate according to any one of claims 1 to 11, wherein the template substrate comprises:
a main substrate; and
an underlying layer,
the underlying layer is not modified in the first seed region, and
the underlying layer is modified in the growth suppression region.

30. The semiconductor substrate according to any one of claims 1 to 11, wherein
the template substrate comprises:
a main substrate;
a buffer part; and
a seed part located above the buffer part,
the seed part comprises the first seed region, and
a region of an upper surface of the buffer part that does not overlap the seed part functions as the growth suppression region.

31. The semiconductor substrate according to any one of claims 1 to 11, wherein the template substrate comprises:
a main substrate; and
a seed part located above the main substrate,
the seed part comprises the first seed region, and
a region of an upper surface of the main substrate that does not overlap the seed part functions as the growth suppression region.

32. A method of manufacturing a semiconductor substrate, the method comprising:
preparing a template substrate comprising a first seed region and a growth suppression region that are aligned in a first direction; and
growing a first semiconductor part comprising a first base portion located on the first seed region and a first wing portion connected to the first base portion and facing the growth suppression region with a first void space interposed between the first wing portion and the growth suppression region, in order for a width of the first wing portion in the first direction to be 5.0 times or more a thickness of the first void space below a wing end.

33. The method of manufacturing a semiconductor substrate according to claim 32, further comprising:
stopping a growth of the first wing portion and a second wing portion growing in a direction toward the first wing portion, before the first wing portion and the second wing portion meet each other.

34. The method of manufacturing a semiconductor substrate according to claim 33, wherein
a ratio of a thickness of the first wing portion with respect to a width of the first wing portion is set to be equal to or less than 1/2, in order for a deviation between a c-axis direction of the first base portion and a c-axis direction of a front end of the first wing portion to be equal to or less than 0.2°.

35. The method of manufacturing a semiconductor substrate according to any one of claims 32 to 34, wherein
the template substrate comprises a seed part comprising a first seed region; and
the seed part is formed by a sputtering method.

36. The method of manufacturing a semiconductor substrate according to claim 35, wherein
a sputtering device is used to cover a surface of a silicon substrate serving as a main substrate with the seed part not containing gallium and a mask portion functioning as the growth suppression region, and then, the silicon substrate and the template substrate comprising the seed part and the mask portion are introduced into an MOCVD device to form the first semiconductor part comprising a GaN-based semiconductor.

37. An apparatus for manufacturing a semiconductor substrate, the apparatus performing the preparing and the growing according to claim 32.

38. A method of manufacturing a semiconductor element, the method comprising:
preparing the semiconductor substrate according to any one of claims 1 to 31;
forming an upper layer portion above the first wing portion; and
peeling the first wing portion from the template substrate while the first wing portion and the upper layer portion are held by a transfer substrate.

39. The method of manufacturing a semiconductor element according to claim 38, wherein
the upper layer portion is not formed below the first wing portion.
